# EUROPEAN PATENT APPLICATION

(11) **EP 4 852 680 A1**
(43) Date of publication of application: **09.12.2026**
(21) Application number: 26182905.5
(22) Date of filing: 03.06.2026
(51) Int. Cl.: H10K 59/38, H10K 59/80, H10K 59/122

(54) **DISPLAY APPARATUS AND ELECTRONIC APPARATUS**

(30) Priority: 04.06.2025 KR 20250073135; 25.09.2025 KR 20250139367
(71) Applicant: Samsung Display Co., Ltd., Yongin-si, Gyeonggi-do 17113 (KR)
(72) Inventor: KIM, Changwook, 17113 Yongin-si (KR); KIM, Deukjong, 17113 Yongin-si (KR); PARK, Chanhyuk, 17113 Yongin-si (KR); LEE, Dongjin, 17113 Yongin-si (KR); JANG, Cheol, 17113 Yongin-si (KR); JEONG, Seongwoo, 17113 Yongin-si (KR)
(74) Representative: Marks & Clerk LLP

(57) **Abstract**

Example embodiments provide a display apparatus including a substrate including a display area and a peripheral area, the display area including a center area and an edge area, a first pixel electrode on the center area, a 2-1 pixel electrode on the edge area, an organic bank layer defining a first pixel opening and a 2-1 pixel opening, an opposite electrode, an encapsulation layer on the opposite electrode, a light-blocking layer on the encapsulation layer and defining a first filter opening that overlaps the first pixel opening and a 2-1 filter opening that overlaps the 2-1 pixel opening, and a light control layer between the encapsulation layer and the light-blocking layer and defining a 2-1 control opening that overlaps the 2-1 pixel opening. The light control layer includes a 2-1 portion that overlaps the 2-1 pixel opening in a plan view.

## Description

### BACKGROUND

Some example embodiments relate to a display apparatus and an electronic apparatus which are capable of improving display quality by reducing differences in optical characteristics according to positions in a display area.

Recently, applications of display apparatuses have been diversifying. In addition, as display apparatuses become thinner and lighter, the range of use of display apparatuses is widening. As the range of use of display apparatuses diversifies, various methods for designing the form of display apparatuses are being researched.

Electrodes of display elements included in a display apparatus, and various other metal wirings, reflect light externally that is incident on the display apparatus. Due to the external light reflection, the display apparatus may have reduced visibility in relatively bright environments.

### SUMMARY

Some example embodiments are directed to a display element that reduces reflection of external incident light. The display element may include a color filter having a color corresponding to light that an emission layer of the display element may emit.

In display apparatuses in the related art, thicknesses of color filters disposed on display elements vary according to positions in a display area, which causes differences in optical characteristics according to positions in the display area, thereby reducing display quality.

Some example embodiments include a display apparatus and an electronic apparatus capable of improving display quality by reducing differences in optical characteristics according to positions in a display area. However, the scope of example embodiments is not limited thereto.

Additional aspects will be set forth in part in the description which follows and, in part, will be apparent from the description, or may be learned by practice of the example embodiments of the disclosure.

According to some example embodiments, a display apparatus includes a substrate including a display area and a peripheral area surrounding the display area, the display area including a center area and an edge area surrounding the center area, a first pixel electrode on the center area, a 2-1 pixel electrode on the edge area, an organic bank layer defining a first pixel opening that exposes a central portion of the first pixel electrode and a 2-1 pixel opening that exposes a central portion of the 2-1 pixel electrode, an opposite electrode on the first pixel electrode and the 2-1 pixel electrode, an encapsulation layer on the opposite electrode, a light-blocking layer on the encapsulation layer and defining a first filter opening that overlaps the first pixel opening and a 2-1 filter opening that overlaps the 2-1 pixel opening, and a light control layer between the encapsulation layer and the light-blocking layer, the light control layer defining a 2-1 control opening that overlaps the 2-1 pixel opening, and the light control layer including a 2-1 portion that overlaps the 2-1 pixel opening in a plan view.

The display apparatus may include a first emission layer between the first pixel electrode and the opposite electrode, a 2-1 emission layer between the 2-1 pixel electrode and the opposite electrode, a first color filter having at least a portion thereof in the first filter opening, and a 2-1 color filter having at least a portion thereof in the 2-1 filter opening.

A thickness of the 2-1 color filter may be smaller than a thickness of the first color filter.

The display apparatus may include a 2-2 pixel electrode on the edge area and closer to the center area than the 2-1 pixel electrode. The organic bank layer may define a 2-2 pixel opening that exposes a central portion of the 2-2 pixel electrode, the light-blocking layer may define a 2-2 filter opening that overlaps the 2-2 pixel opening, the light control layer may define a 2-2 control opening that overlaps the 2-2 pixel opening, the light control layer may include a 2-2 portion that overlaps the 2-2 pixel opening in a plan view, and an area of the 2-2 portion may be smaller than an area of the 2-1 portion.

The light control layer may be on the center area and the edge area, and the light control layer may define a first control opening that overlaps the first pixel opening.

An area of the first control opening may be equal to an area of the first pixel opening.

The light control layer may include a first portion that overlaps the first pixel opening in a plan view, and an area of the first portion may be smaller than an area of the 2-1 portion.

The encapsulation layer may include a first inorganic encapsulation layer, a second inorganic encapsulation layer, and an organic encapsulation layer, the first inorganic encapsulation layer may be on the opposite electrode, the second inorganic encapsulation layer may be on the first inorganic encapsulation layer, and the organic encapsulation layer may be between the first inorganic encapsulation layer and the second inorganic encapsulation layer.

A transmittance of the light control layer may be equal to or greater than 19.9% and equal to or less than 70.8%, and a transmittance of the light-blocking layer may be equal to or greater than 4.0% and equal to or less than 6.4%.

An area A1 of the 2-1 pixel opening that does not overlap the 2-1 portion in a plan view, an area A2 of the 2-1 pixel opening that overlaps the 2-1 portion in a plan view, and a transmittance T of the light control layer may satisfy a relationship $0.85 < \frac{A 1 + T \times A 2}{A 1 + A 2} < 1.0$ .

According to some example embodiments, a display apparatus includes a substrate including a display area and a peripheral area surrounding the display area, the display area including a center area and an edge area surrounding the center area, a 2-1 pixel electrode on the edge area, a first pixel electrode on the center area, an organic bank layer defining a 2-1 pixel opening that exposes a central portion of the 2-1 pixel electrode and a first pixel opening that exposes a central portion of the first pixel electrode, an opposite electrode on the 2-1 pixel electrode and the first pixel electrode, an encapsulation layer on the opposite electrode, a light-blocking layer on the encapsulation layer and defining a 2-1 filter opening that overlaps the 2-1 pixel opening and a first filter opening that overlaps the first pixel opening, and a light control layer on the encapsulation layer, the light control layer including a 2-1 portion in the 2-1 filter opening that overlaps the 2-1 pixel opening in a plan view.

The display apparatus may include a 2-1 emission layer between the 2-1 pixel electrode and the opposite electrode, a first emission layer between the first pixel electrode and the opposite electrode, a 2-1 color filter having at least a portion thereof in the 2-1 filter opening and covering the 2-1 portion, and a first color filter having at least a portion thereof in the first filter opening.

A thickness of the 2-1 color filter may be smaller than a thickness of the first color filter.

The display apparatus may include a 2-2 pixel electrode on the edge area and closer to the center area than the 2-1 pixel electrode. The organic bank layer may define a 2-2 pixel opening that exposes a central portion of the 2-2 pixel electrode, the light-blocking layer may define a 2-2 filter opening that overlaps the 2-2 pixel opening, the light control layer may define a 2-2 control opening that overlaps the 2-2 pixel opening, the light control layer may include a 2-2 portion in the 2-2 filter opening and overlapping the 2-2 pixel opening in a plan view, and an area of the 2-2 portion may be smaller than an area of the 2-1 portion.

The light control layer may include a first portion in the first filter opening that overlaps the first pixel opening in a plan view, and an area of the first portion may be smaller than an area of the 2-1 portion.

The encapsulation layer may include a first inorganic encapsulation layer, a second inorganic encapsulation layer, and an organic encapsulation layer, the first inorganic encapsulation layer may be on the opposite electrode, the second inorganic encapsulation layer may be on the first inorganic encapsulation layer, and the organic encapsulation layer may be between the first inorganic encapsulation layer and the second inorganic encapsulation layer.

A transmittance of the light control layer may be equal to or greater than 19.9% and equal to or less than 70.8%, and a transmittance of the light-blocking layer may be equal to or greater than 4.0% and equal to or less than 6.4%.

An area A1 of the 2-1 pixel opening that does not overlap the 2-1 portion in a plan view, an area A2 of the 2-1 pixel opening that overlaps the 2-1 portion in a plan view, and a transmittance T of the light control layer may satisfy a relationship
$0.85 < \frac{A 1 + T \times A 2}{A 1 + A 2} < 1.0 .$

According to some example embodiments, an electronic apparatus includes a display apparatus and a processor configured to control the display apparatus. The display apparatus includes a substrate including a display area including a center area and an edge area surrounding the center area, and a peripheral area surrounding the display area, a 2-1 pixel electrode on the edge area, a first pixel electrode on the center area, an organic bank layer defining a 2-1 pixel opening that exposes a central portion of the 2-1 pixel electrode and a first pixel opening that exposes a central portion of the first pixel electrode, an opposite electrode on the 2-1 pixel electrode and the first pixel electrode, an encapsulation layer on the opposite electrode, a light-blocking layer on the encapsulation layer and defining a 2-1 filter opening that overlaps the 2-1 pixel opening and a first filter opening that overlaps the first pixel opening, and a light control layer between the encapsulation layer and the light-blocking layer. The light control layer defines a 2-1 control opening that overlaps the 2-1 pixel opening, and the light control layer includes a 2-1 portion that overlaps the 2-1 pixel opening in a plan view.

The display apparatus may include a 2-1 emission layer between the 2-1 pixel electrode and the opposite electrode, a first emission layer between the first pixel electrode and the opposite electrode, a 2-1 color filter having at least a portion thereof in the 2-1 filter opening, and a first color filter having at least a portion thereof in the first filter opening.

At least some of the above and other features of the invention are set out in the claims.

Other aspects, features, and advantages other than those described above will become apparent from the detailed description, claims, and drawings below.

### BRIEF DESCRIPTION OF THE DRAWINGS

The above and other aspects, features, and advantages of example embodiments of the disclosure will be more apparent from the following description taken in conjunction with the accompanying drawings, in which:
FIG. 1A is a block diagram schematically illustrating an electronic apparatus according to some example embodiments of the disclosure.
FIG. 1B schematically illustrates electronic apparatuses according to some example embodiments of the disclosure.
FIG. 2 is a plan view schematically illustrating a display apparatus according to some example embodiments of the disclosure.
FIG. 3 is an equivalent circuit diagram of a pixel circuit included in the display apparatus of FIG. 2.
FIG. 4 is a plan view schematically illustrating an enlarged portion A of the display apparatus of FIG. 2.
FIG. 5 is a cross-sectional view schematically illustrating a cross-section taken along line I-I' of the display apparatus of FIG. 4.
FIG. 6 is a view for explaining pixels distinguished according to positions in a display area.
FIG. 7 is a plan view schematically illustrating an enlarged portion B of the display apparatus of FIG. 2.
FIG. 8 is a cross-sectional view schematically illustrating a cross-section taken along line II-II' of the display apparatus of FIG. 7.
FIG. 9 is a plan view schematically illustrating a display apparatus according to some example embodiments of the disclosure.
FIG. 10 is a plan view schematically illustrating a display apparatus according to some example embodiments of the disclosure.
FIG. 11 is a plan view schematically illustrating a display apparatus according to some example embodiments of the disclosure.
FIG. 12 is a cross-sectional view schematically illustrating a cross-section taken along line III-III' of the display apparatus of FIG. 11.
FIG. 13 is a plan view schematically illustrating a display apparatus according to some example embodiments of the disclosure.
FIG. 14 is a cross-sectional view schematically illustrating a cross-section taken along line IV-IV' of the display apparatus of FIG. 13.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

The disclosure may have various modifications and various embodiments, and specific embodiments are illustrated in the drawings and will be described in detail in the detailed description. Effects and features of the disclosure, and methods for achieving them will become apparent with reference to embodiments described below in detail together with the drawings. However, the disclosure is not limited to the embodiments disclosed below and may be implemented in various forms.

In this specification, terms such as first and second are used for the purpose of distinguishing one component from another component, not in a limiting sense.

In this specification, singular expressions include plural expressions unless the context clearly indicates otherwise.

In this specification, terms such as "include" or "have" mean that a feature or component described in the specification is present, and do not exclude in advance the possibility that one or more other features or components may be added.

In this specification, "A and/or B" indicates a case where A, B, or both A and B. In addition, "at least one of A and B" indicates a case where A, B, or both A and B.

In this specification, when various components such as layers, films, areas, and plates are "on" other components, this includes not only a case where the components are "directly on" other components, but also a case where other components are disposed therebetween.

In this specification, when layers, films, areas, components, and the like are connected, this includes a case where the layers, films, areas, and components are directly connected, and/or a case where the layers, films, areas, and components are indirectly connected with other layers, films, areas, and components disposed therebetween. For example, in this specification, when layers, films, areas, components, and the like are electrically connected, this indicates a case where the layers, films, areas, components, and the like are directly electrically connected, and/or a case where the layers, films, areas, components, and the like are indirectly electrically connected with other layers, films, areas, components, and the like disposed therebetween.

In this specification, an x-axis, a y-axis, and a z-axis are not limited to three axes on a Cartesian coordinate system, and may be interpreted in a broad sense including the same. For example, the x-axis, the y-axis, and the z-axis may be orthogonal to each other, but may also refer to different directions that are not orthogonal to each other.

In this specification, when some example embodiments may be implemented differently, a specific process order may be performed differently from a described order. For example, two processes described consecutively may be performed substantially simultaneously, or may be performed in an order opposite to the described order.

In this specification, "in a plan view" means when a target portion is viewed from above. For example, in this specification, "in a plan view" may mean "when viewed from a direction perpendicular to a substrate 100."

In the drawings, the thickness of layers, films, panels, regions, etc., are exaggerated for clarity.

It will be understood that when an element such as a layer, film, region, or substrate is referred to as being "on" another element, it may be directly on the other element or intervening elements may also be present. In contrast, when an element is referred to as being "directly on" another element, there are no intervening elements present. It will further be understood that when an element is referred to as being "on" another element, it may be above or beneath or adjacent (e.g., horizontally adjacent) to the other element.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

Hereinafter, some example embodiments of the disclosure will be described in detail with reference to the accompanying drawings, and when describing with reference to the drawings, identical or corresponding components are given the same reference numerals, and redundant descriptions thereof will be omitted. For convenience of description, sizes of components may be exaggerated or reduced in the drawings. For example, since sizes and thicknesses of components shown in the drawings are arbitrarily shown for convenience of description, the disclosure is not necessarily limited to what is shown.

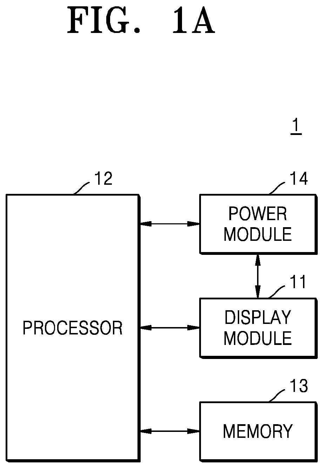

FIG. 1A is a block diagram schematically illustrating an electronic apparatus 1 according to some example embodiments of the disclosure. The electronic apparatus 1 may further include a module having other additional functions in addition to a display module 11. For example, as illustrated in FIG. 1A, the electronic apparatus 1 may include the display module 11, a processor 12, a memory 13, and a power module 14.

The processor 12 may control components of the electronic apparatus 1. The processor 12 may include at least one of a central processing unit (CPU), an application processor (AP), a graphic processing unit (GPU), a communication processor (CP), an image signal processor (ISP), and a controller.

The memory 13 may store data information necessary for operations of the processor 12 or the display module 11. When the processor 12 executes an application stored in the memory 13, a data signal and/or an input control signal for an image may be transmitted to the display module 11, and the display module 11 may process the received signal to output image information.

The power module 14 may include a power supply module such as a power adapter or a battery device, and a power conversion module configured to convert power supplied by the power supply module to generate power for an operation of the electronic apparatus 1.

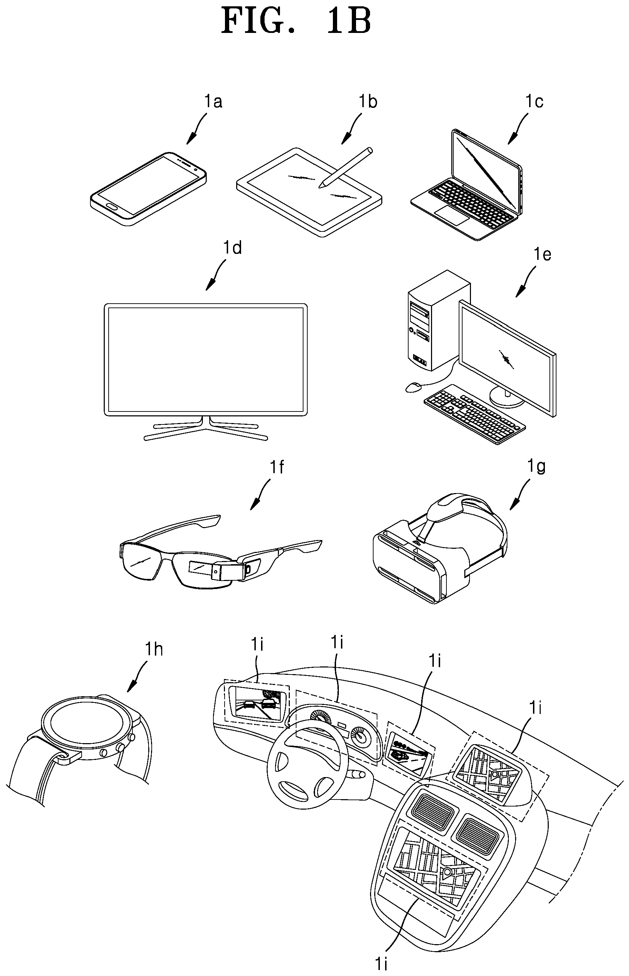

FIG. 1B schematically illustrates electronic apparatuses 1 according to embodiments of the disclosure. Referring to FIG. 1B, the electronic apparatuses 1 including the display module 11 may include electronic apparatuses for displaying images such as a smartphone 1a, a tablet personal computer (PC) 1b, a laptop 1c, a television (TV) 1d, and a desktop monitor 1e, wearable electronic apparatuses including a display module such as smart glasses 1f, a head mounted display 1g, and a smart watch 1h, and a vehicle electronic apparatus 1i including a display module such as an instrument panel of a vehicle, a center fascia, a Center Information Display (CID) disposed on a dashboard, and a room mirror display.

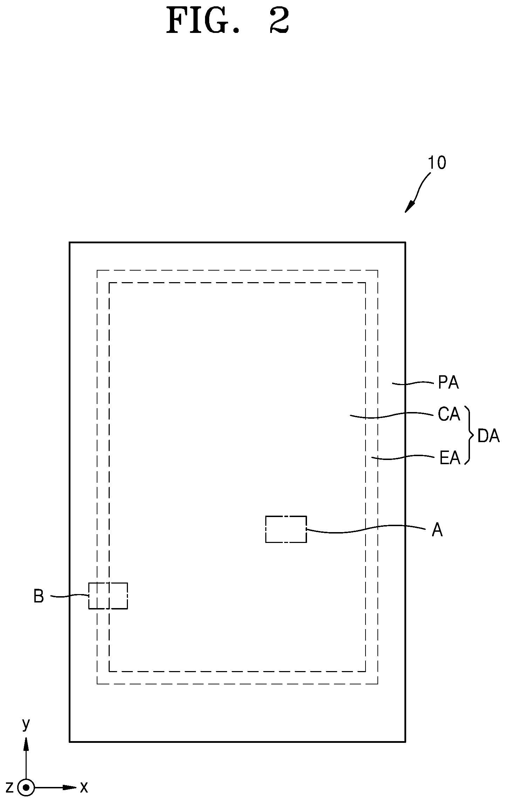

In addition, the display module 11 may include a display apparatus 10 (refer to FIG. 2). The display apparatus 10 may be used in various electronic apparatuses 1. For example, the electronic apparatus 1 includes the display apparatus 10, and may further include a module or an apparatus having other additional functions in addition to the display apparatus 10. For example, the electronic apparatus 1 may include the display apparatus 10, the processor 12, the memory 13, and the power module 14, and the display apparatus 10 may be controlled by the processor 12. Hereinafter, the display apparatus 10 is discussed below.

FIG. 2 is a plan view schematically illustrating a display apparatus 10 according to some example embodiments of the disclosure. As illustrated in FIG. 2, the display apparatus 10 includes a display area DA and a peripheral area PA outside the display area DA, for example, along an edge or periphery of the display area DA.

When the display area DA is viewed in a plan view, the display area DA may have a generally rectangular shape as illustrated in FIG. 2. However, example embodiments are not limited thereto, and the display area DA may have a polygonal shape such as a triangular shape, a pentagonal shape, or a hexagonal shape, a circular shape, an elliptical shape, or an atypical shape. The peripheral area PA may be a non-display area in which display elements are not disposed. The peripheral area PA surrounds the display area DA.

A plurality of pixels may be disposed in the display area DA. Each pixel of the display apparatus 10 is capable of emitting light of a certain color, and the display apparatus 10 may provide an image by using light emitted from the pixels. In some example embodiments, the pixels of the display apparatus 10 may be disposed in various forms such as a stripe arrangement, a PenTile arrangement, or a mosaic arrangement along an x-axis direction and a y-axis direction to display an image. For example, each pixel may emit green light, red light, or blue light. One pixel may correspond to one display element. In this specification, that one pixel corresponds to one display element or that one display element corresponds to one pixel means that one pixel is an emission area of one display element.

The display area DA includes a center area CA and an edge area EA. When viewed from a direction substantially perpendicular to an upper surface of the display apparatus 10 (for example, a z-axis direction), the center area CA may have a generally rectangular shape as illustrated in FIG. 2. However, example embodiments are not limited thereto, and the center area CA may have a polygonal shape such as a triangular shape, a quadrangular shape, a pentagonal shape, or a hexagonal shape, a circular shape, an elliptical shape, a star shape, or an atypical shape. The edge area EA may surround the center area CA. For example, the edge area EA may be a portion of the display area DA adjacent to the peripheral area PA.

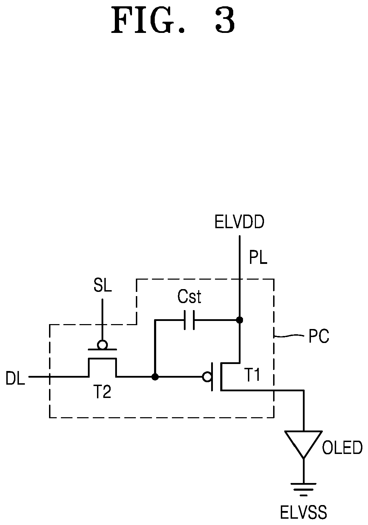

The peripheral area PA may be a non-display area in which pixels are not disposed. A driver for providing an electrical signal or power to display elements corresponding to the pixels may be disposed in the peripheral area PA. In addition, pads may be disposed in the peripheral area PA, and an electronic device or a printed circuit board may be electrically connected to the pads. Each of the pads may be disposed spaced apart from each other in the peripheral area PA, and each of the pads may be electrically connected to a plurality of connection wirings disposed in the peripheral area PA. The connection wirings may electrically connect signal lines disposed in the display area DA, for example, data lines DL (refer to FIG. 3) (or scan lines SL (refer to FIG. 3)) and the pads.

FIG. 3 is an equivalent circuit diagram of a pixel circuit PC included in the display apparatus 10 of FIG. 2. The pixel circuit PC may be electrically connected to a display element, and one display element may correspond to one pixel. In FIG. 3, an organic light emitting diode OLED is illustrated as the display element.

The pixel circuit PC may include a first transistor T1, a second transistor T2, and a storage capacitor Cst. The second transistor T2 is a switching transistor, is connected to a scan line SL and a data line DL, and may be turned on by a switching signal input from the scan line SL to transmit a data signal input from the data line DL to the first transistor T1. The storage capacitor Cst has one end electrically connected to the second transistor T2 and the other end electrically connected to a driving voltage line PL, and may store a voltage corresponding to a difference between a voltage received from the second transistor T2 and a driving power voltage ELVDD supplied to the driving voltage line PL.

The first transistor T1 is a driving transistor, is connected to the driving voltage line PL and the storage capacitor Cst, and may control a magnitude of a driving current flowing from the driving voltage line PL to the organic light emitting diode OLED in response to a voltage value stored in the storage capacitor Cst. The organic light emitting diode OLED may emit light having a certain or desired luminance according to the driving current. An opposite electrode of the organic light emitting diode OLED may receive an electrode power voltage ELVSS.

FIG. 3 illustrates that the pixel circuit PC includes two transistors and one storage capacitor, but example embodiments are not limited thereto. For example, the number of transistors or the number of storage capacitors may be changed depending on application and/or design of the pixel circuit PC.

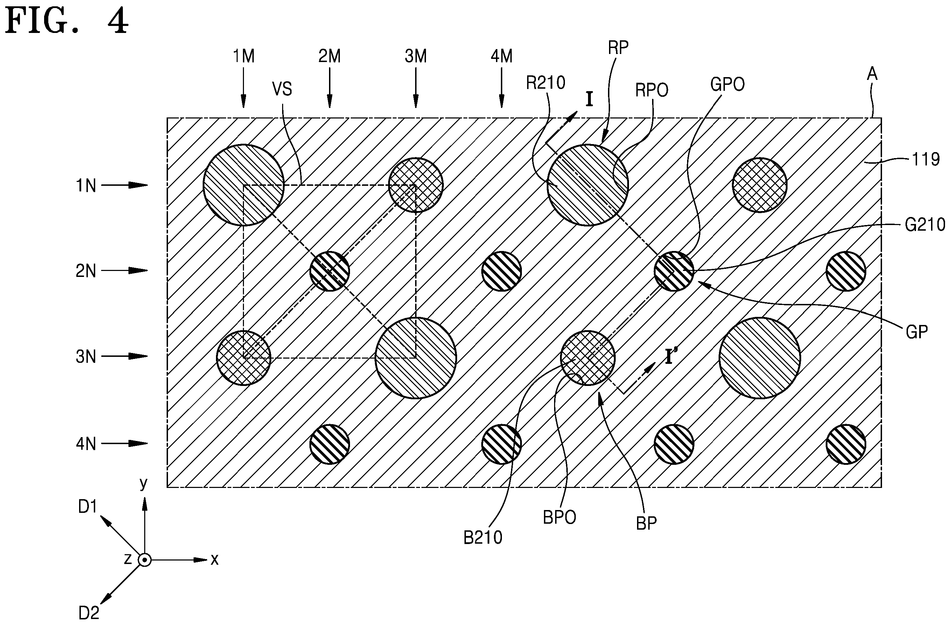

FIG. 4 is a plan view schematically illustrating an enlarged portion A of the display apparatus 10 of FIG. 2. In FIG. 4, a plan view on an organic bank layer 119 is illustrated for convenience.

As described above, a plurality of pixels may be disposed in the display area DA. The plurality of pixels may emit, for example, red light, green light, or blue light. For example, each of the plurality of pixels refers to a sub-pixel, and the plurality of pixels may include a red pixel RP, a green pixel GP, and a blue pixel BP. The red pixel RP may be a pixel emitting red light, the green pixel GP may be a pixel emitting green light, and the blue pixel BP may be a pixel emitting blue light. The red light may be light belonging to a wavelength band of 580 nm (or about 580 nm) to 780 nm (or about 780 nm), the green light may be light belonging to a wavelength band of 495 nm (or about 495 nm) to 580 nm (or about 580 nm), and the blue light may be light belonging to a wavelength band of 400 nm (or about 400 nm) to 495 nm (or about 495 nm).

A plurality of red pixels RP may be provided, a plurality of green pixels GP may be provided, and a plurality of blue pixels BP may be provided. The red pixels RP, the green pixels GP, and the blue pixels BP may be arranged based on a certain or desired rule, for example, in a desired pattern, in the display area DA.

In some example embodiments, the red pixels RP, the green pixels GP, and the blue pixels BP may be disposed in a PenTile structure as illustrated in FIG. 4. For example, a plurality of red pixels RP and a plurality of blue pixels BP may be alternately disposed in a first row 1N, a plurality of green pixels GP may be disposed spaced apart from each other by a certain or desired interval in an adjacent second row 2N, a plurality of blue pixels BP and a plurality of red pixels RP may be alternately disposed in an adjacent third row 3N, and a plurality of green pixels GP may be disposed spaced apart from each other by a certain or desired interval in an adjacent fourth row 4N. Such an arrangement of pixels may be repeated up to an Nth row. At this time, sizes (or areas) of the red pixel RP, the green pixel GP, and the blue pixel BP may be different from each other. In some example embodiments, a size (or area) of each of the red pixel RP and the blue pixel BP may be larger than a size (or area) of the green pixel GP.

The plurality of red pixels RP and the plurality of blue pixels BP disposed in the first row 1N and the plurality of green pixels GP disposed in the second row 2N may be disposed to be staggered from each other. Accordingly, a plurality of red pixels RP and a plurality of blue pixels BP may be alternately disposed in a first column 1M, a plurality of green pixels GP may be disposed spaced apart from each other by a certain or desired interval in an adjacent second column 2M, a plurality of blue pixels BP and a plurality of red pixels RP may be alternately disposed in an adjacent third column 3M, and a plurality of green pixels GP may be disposed spaced apart from each other by a certain or desired interval in an adjacent fourth column 4M. Such an arrangement of pixels may be repeated up to an Mth column.

In other words, such a pixel arrangement structure may be expressed as a red pixel RP being disposed at a first vertex and a third vertex facing each other (e.g., diagonally opposite each other) among vertices of an imaginary quadrangle VS having a center point of the green pixel GP as a center point of the quadrangle, and a blue pixel BP being disposed at a second vertex and a fourth vertex (diagonally opposite each other) which are the remaining vertices. The imaginary quadrangle VS is merely an example configuration of a pixel arrangement, and the pixel may be arranged in other different configurations such as a rectangle, a rhombus, or a square.

Such a pixel arrangement structure may be referred to as a PenTile Matrix structure or a PenTile structure. In the case of such a pixel arrangement structure, a rendering driving that expresses colors by sharing adjacent pixels may be applied. Accordingly, a relatively higher resolution may be implemented with a relatively smaller number of pixels.

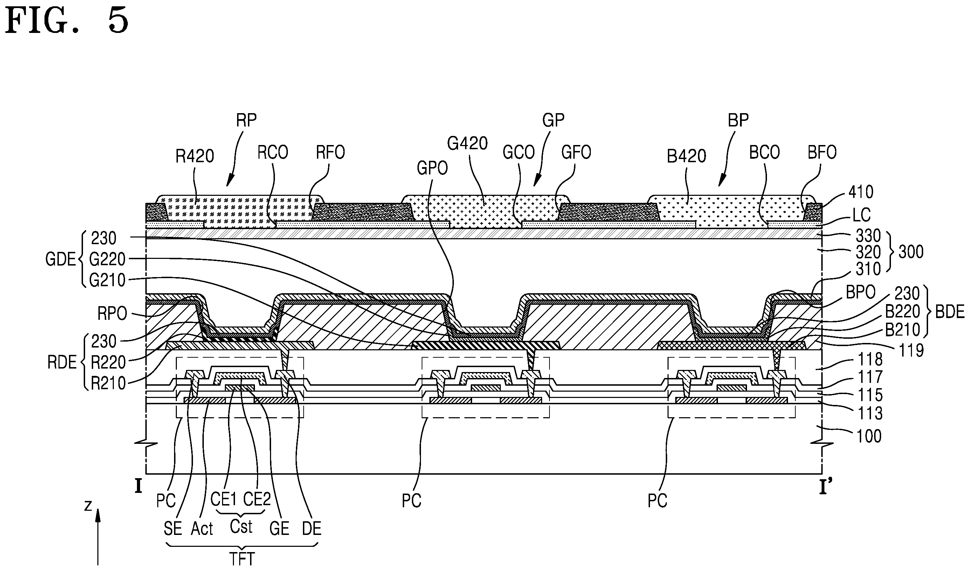

A display element such as an organic light emitting diode may correspond to each pixel. In some example embodiments, each of a plurality of display elements included in the display apparatus 10 corresponds to each pixel of the display apparatus 10, and each of the plurality of display elements may emit light. For example, a red display element RDE (refer to FIG. 5) may correspond to the red pixel RP, a green display element GDE (refer to FIG. 5) may correspond to the green pixel GP, and a blue display element BDE (refer to FIG. 5) may correspond to the blue pixel BP.

A red pixel electrode R210 included in the red display element RDE, a green pixel electrode G210 included in the green display element GDE, and a blue pixel electrode B210 included in the blue display element BDE may be disposed in the display area DA. For example, the red pixel electrode R210, the green pixel electrode G210, and the blue pixel electrode B210 may be disposed spaced apart from each other in a plan view. The red pixel electrode R210, the green pixel electrode G210, and the blue pixel electrode B210 may have different sizes from each other. Alternatively, in some example embodiments, the red pixel electrode R210, the green pixel electrode G210, and the blue pixel electrode B210 may have the same size as each other.

The organic bank layer 119 may be disposed on the red pixel electrode R210, the green pixel electrode G210, and the blue pixel electrode B210. The organic bank layer 119 may define a red pixel opening RPO, a green pixel opening GPO, and a blue pixel opening BPO. The red pixel opening RPO and the green pixel opening GPO may be disposed to be adjacent to each other along a first direction (for example, a direction between a -x direction and a +y direction, that is, a D1 direction), and the blue pixel opening BPO may be disposed to be adjacent to the green pixel opening GPO along a second direction (for example, a direction between a -x direction and a -y direction, that is, a D2 direction).

The red pixel opening RPO may expose a central portion of the red pixel electrode R210, the green pixel opening GPO may expose a central portion of the green pixel electrode G210, and the blue pixel opening BPO may expose a central portion of the blue pixel electrode B210. The red pixel opening RPO, the green pixel opening GPO, and the blue pixel opening BPO may have different sizes from each other as illustrated in FIG. 4. Alternatively, in some example embodiments, the red pixel opening RPO, the green pixel opening GPO, and the blue pixel opening BPO may have the same size as each other.

Emission layers emitting light may be disposed in the red pixel opening RPO, the green pixel opening GPO, and the blue pixel opening BPO of the organic bank layer 119, respectively. An opposite electrode may be disposed on the emission layers. A stacked structure of a pixel electrode, an emission layer, and an opposite electrode may form one organic light emitting diode. One opening of the organic bank layer 119 corresponds to one organic light emitting diode and may define one emission area.

For example, an emission layer emitting red light may be disposed in the red pixel opening RPO, and an emission area defined by the red pixel opening RPO may be defined as the red pixel RP. Similarly, an emission layer emitting green light may be disposed in the green pixel opening GPO, and an emission area defined by the green pixel opening GPO may be defined as the green pixel GP. Similarly, an emission layer emitting blue light may be disposed in the blue pixel opening BPO, and an emission area defined by the blue pixel opening BPO may be defined as the blue pixel BP. However, example embodiments are not limited thereto.

FIG. 5 is a cross-sectional view schematically illustrating a cross-section taken along line I-I' of the display apparatus 10 of FIG. 4. In addition, as will be understood by those of ordinary skill in the art, the display apparatus 10 may further include various other components in addition to the components illustrated in FIG. 5.

As illustrated in FIG. 5, the display apparatus 10 includes a substrate 100. The substrate 100 may include various materials having flexible or bendable characteristics. For example, the substrate 100 may include glass, metal, or polymer resin. In addition, the substrate 100 may include a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. In addition, various modifications are possible, such as the substrate 100 may have a multilayer structure including two layers each including such a polymer resin and a barrier layer including an inorganic material (such as silicon oxide (SiO_{X}), silicon nitride (SiN_{X}), and/or silicon oxynitride (SiO_{X}N_{Y})) disposed between the layers.

Since the display apparatus 10 includes the substrate 100, the substrate 100 may be described to have the display area DA and the peripheral area PA. Hereinafter, for convenience of explanation, the substrate 100 will be described as having the display area DA and the peripheral area PA.

Display elements corresponding to each of a plurality of pixels and a plurality of pixel circuits PC electrically connected to each of the display elements may be disposed on the display area DA of the substrate 100. In some example embodiments, a red display element RDE, a green display element GDE, and a blue display element BDE may be disposed on the display area DA of the substrate 100. The red display element RDE may correspond to the red pixel RP, the green display element GDE may correspond to the green pixel GP, and the blue display element BDE may correspond to the blue pixel BP. The red display element RDE, the green display element GDE, and the blue display element BDE may be electrically connected to a corresponding one of the plurality of pixel circuits PC.

Since structures of the plurality of pixel circuits PC electrically connected to each of the display elements are the same as each other, a description will be provided of one pixel circuit PC. The pixel circuit PC includes a plurality of transistors TFT and a storage capacitor Cst. For convenience of illustration, one transistor TFT is illustrated in FIG. 5, and this transistor TFT may correspond to the first transistor T1 (refer to FIG. 3) described above.

As illustrated in FIG. 5, the transistor TFT may include a semiconductor layer Act including amorphous silicon, polycrystalline silicon, an organic semiconductor material, or an oxide semiconductor material. In addition, the transistor TFT may include a gate electrode GE, a source electrode SE, and/or a drain electrode DE. The gate electrode GE includes various conductive materials and may have various layered structures, for example, may include a Mo layer and an Al layer. Alternatively, the gate electrode GE may include a TiN_{X} layer, an Al layer, and/or a Ti layer. The source electrode SE and the drain electrode DE also include various conductive materials and may have various layered structures, for example, may include a Ti layer, an Al layer, and/or a Cu layer.

A gate insulating layer 113 including an inorganic material such as silicon oxide (SiO_{X}), silicon nitride (SiN_{X}), and/or silicon oxynitride (SiO_{X}N_{Y}) may be disposed between the semiconductor layer Act and the gate electrode GE to secure insulation between the semiconductor layer Act and the gate electrode GE. In FIG. 5, the gate insulating layer 113 is illustrated as having a shape corresponding to an entire surface of the substrate 100 and having a structure in which contact holes are formed in a preset or desired portion, but example embodiments are not limited thereto. For example, the gate insulating layer 113 may be patterned in the same shape as the gate electrode GE.

In addition, a first interlayer insulating layer 115 including an inorganic insulating material such as silicon oxide (SiO_{X}), silicon nitride (SiN_{X}), and/or silicon oxynitride (SiO_{X}N_{Y}) may be disposed on the gate electrode GE. The first interlayer insulating layer 115 may have a single-layer or multi-layer structure including the material described above. As such, an insulating layer including an inorganic insulating material may be formed through chemical vapor deposition (CVD) or atomic layer deposition (ALD). These techniques may also be used in the example embodiments and variations thereof described below.

The storage capacitor Cst may include a first capacitor electrode CE1 and a second capacitor electrode CE2 overlapping each other with the first interlayer insulating layer 115 disposed therebetween. The storage capacitor Cst may overlap the transistor TFT. In this regard, FIG. 5 illustrates that the gate electrode GE of the transistor TFT is the first capacitor electrode CE1 of the storage capacitor Cst, but example embodiments are not limited thereto. For example, the storage capacitor Cst may not overlap the transistor TFT. The second capacitor electrode CE2 of the storage capacitor Cst may include a conductive material including molybdenum (Mo), aluminium (Al), copper (Cu), or titanium (Ti), and may have a multi-layer or single-layer structure including such a material.

A second interlayer insulating layer 117 including an inorganic material such as silicon oxide (SiO_{X}), silicon nitride (SiN_{X}), and/or silicon oxynitride (SiO_{X}N_{Y}) may be disposed on the second capacitor electrode CE2 of the storage capacitor Cst. The second interlayer insulating layer 117 may have a single-layer or multi-layer structure including the material described above.

The source electrode SE and the drain electrode DE may be disposed on the second interlayer insulating layer 117. The source electrode SE and the drain electrode DE may include a material having relatively higher conductivity. The source electrode SE and the drain electrode DE may include a conductive material including molybdenum (Mo), aluminium (Al), copper (Cu), or titanium (Ti), and may have a multi-layer or single-layer structure including such a material. For example, the source electrode SE and the drain electrode DE may have a multi-layer structure of Ti/Al/Ti.

However, example embodiments are not limited thereto. For example, the transistor TFT may include only one of the source electrode SE and the drain electrode DE, or may not include both of them. For example, a first transistor TFT may not have the drain electrode DE, a second transistor TFT connected to the first transistor TFT may not have the source electrode SE, and the semiconductor layers Act of these two transistors may be connected to each other. Such a connection structure may bring the same effect as one transistor TFT having the drain electrode DE and another transistor TFT having the source electrode SE, and the drain electrode DE of the one transistor TFT being connected to the source electrode SE of the another transistor TFT.

As illustrated in FIG. 5, a planarization layer 118 may be disposed to cover the transistor TFT and the storage capacitor Cst. In some example embodiments, the planarization layer 118 may be disposed on the substrate 100. The planarization layer 118 may include an organic insulating material. For example, the planarization layer 118 may include photoresist, Benzocyclobutene (BCB), polyimide, Hexamethyldisiloxane (HMDSO), Polymethylmethacrylate (PMMA), Polystyrene, a polymer derivative having a phenol-based group, an acrylic polymer, an imide-based polymer, an aryl ether-based polymer, an amide-based polymer, a fluorine-based polymer, a p-xylene-based polymer, a vinyl alcohol-based polymer, or a mixture thereof. A third interlayer insulating layer may be further disposed below the planarization layer 118. The third interlayer insulating layer may include an inorganic insulating material such as silicon oxide (SiO_{X}), silicon nitride (SiN_{X}), and/or silicon oxynitride (SiO_{X}N_{Y}).

The plurality of display elements may be disposed on the planarization layer 118. In some example embodiments, the red display element RDE, the green display element GDE, and the blue display element BDE may be disposed spaced apart from each other on the planarization layer 118. The red display element RDE may include a red pixel electrode R210, a red emission layer R220, and an opposite electrode 230. The green display element GDE may include a green pixel electrode G210, a green emission layer G220, and the opposite electrode 230. The blue display element BDE may include a blue pixel electrode B210, a blue emission layer B220, and the opposite electrode 230. In some example embodiments, the opposite electrode 230 of the red display element RDE, the green display element GDE, and the blue display element BDE may be integrally provided over the red display element RDE, the green display element GDE, and the blue display element BDE.

In some example embodiments, the red pixel electrode R210, the green pixel electrode G210, and the blue pixel electrode B210 may be disposed spaced apart from each other on the planarization layer 118. The red pixel electrode R210, the green pixel electrode G210, and the blue pixel electrode B210 may include a light-transmitting conductive layer formed of a light-transmitting conductive oxide such as ITO, In₂O₃, or IZO, and a reflective layer formed of a metal such as Al or Ag. For example, the red pixel electrode R210, the green pixel electrode G210, and the blue pixel electrode B210 may have a three-layer structure of ITO/Ag/ITO.

The red pixel electrode R210, the green pixel electrode G210, and the blue pixel electrode B210 may be in contact with one of the source electrode SE and the drain electrode DE to be electrically connected to the transistor TFT as illustrated in FIG. 5. In some example embodiments, each of the red pixel electrode R210, the green pixel electrode G210, and the blue pixel electrode B210 may be in contact with one of the source electrode SE and the drain electrode DE through a contact hole formed in the planarization layer 118.

The organic bank layer 119 may be disposed on the planarization layer 118. The organic bank layer 119 serves to define an emission area of a display element by defining an opening corresponding to a pixel, for example, an opening exposing at least a central portion of a pixel electrode. In some example embodiments, the organic bank layer 119 may define a red pixel opening RPO, a green pixel opening GPO, and a blue pixel opening BPO. The red pixel opening RPO may expose a central portion of the red pixel electrode R210, the green pixel opening GPO may expose a central portion of the green pixel electrode G210, and the blue pixel opening BPO may expose a central portion of the blue pixel electrode B210.

In addition, as illustrated in FIG. 5, the organic bank layer 119 may increase a distance between an edge of the red pixel electrode R210 and the opposite electrode 230. Similarly, the organic bank layer 119 may increase a distance between an edge of the green pixel electrode G210 and the opposite electrode 230, and may increase a distance between an edge of the blue pixel electrode B210 and the opposite electrode 230. Accordingly, an arc or the like may be reduced or limited or prevented from occurring at an edge of the red pixel electrode R210, an edge of the green pixel electrode G210, or an edge of the blue pixel electrode B210. The organic bank layer 119 may include, for example, an organic material such as polyimide or hexamethyldisiloxane (HMDSO).

The red emission layer R220 may be disposed on the red pixel electrode R210. The green emission layer G220 may be disposed on the green pixel electrode G210, and the blue emission layer B220 may be disposed on the blue pixel electrode B210. In other words, the red emission layer R220 may be disposed in the red pixel opening RPO. The green emission layer G220 may be disposed in the green pixel opening GPO, and the blue emission layer B220 may be disposed in the blue pixel opening BPO.

The red emission layer R220, the green emission layer G220, and the blue emission layer B220 may include an organic material including a fluorescent or phosphorescent material emitting red light, green light, or blue light. In some example embodiments, the red emission layer R220 may include an organic material including a fluorescent or phosphorescent material emitting red light, the green emission layer G220 may include an organic material including a fluorescent or phosphorescent material emitting green light, and the blue emission layer B220 may include an organic material including a fluorescent or phosphorescent material emitting blue light.

The red emission layer R220, the green emission layer G220, and the blue emission layer B220 may be organic emission layers including a low molecular weight organic material or a high molecular weight organic material. For example, the red emission layer R220, the green emission layer G220, and the blue emission layer B220 may be organic emission layers, and may include copper phthalocyanine, tris-8-hydroxyquinoline aluminium, a Poly-Phenylenevinylene (PPV)-based material, or a Polyfluorene-based material.

In some example embodiments, the red emission layer R220, the green emission layer G220, and the blue emission layer B220 may include a host material and a dopant material. The dopant material is a material emitting a specific color, and may include an emission material. The emission material may include at least one of a phosphorescent dopant, a fluorescent dopant, and a quantum dot. The host material is a main material of the red emission layer R220, the green emission layer G220, and the blue emission layer B220, and is a material configured to help the dopant material emit light.

In some example embodiments, a functional layer may be disposed below and above the red emission layer R220, the green emission layer G220, and the blue emission layer B220. The functional layer may include a hole injection layer (HIL), a hole transport layer (HTL), an electron transport layer (ETL), and/or an electron injection layer (EIL). The functional layer may be integral across the red pixel electrode R210, the green pixel electrode G210, and the blue pixel electrode B210.

The opposite electrode 230 may be disposed on the red emission layer R220, the green emission layer G220, and the blue emission layer B220. The opposite electrode 230 disposed on the red emission layer R220, the green emission layer G220, and the blue emission layer B220 may be integrally formed. The opposite electrode 230 may be a light-transmitting electrode or a reflective electrode. In some example embodiments, the opposite electrode 230 may be a transparent or translucent electrode, and may include a metal thin film having a low work function including Li, Ca, LiF/Ca, LiF/Al, Al, Ag, Mg, and compounds thereof. In addition, the opposite electrode 230 may further include a transparent conductive oxide (TCO) film such as ITO, IZO, ZnO, or In₂O₃ in addition to the metal thin film.

An encapsulation layer 300 may be disposed on the red display element RDE, the green display element GDE, and the blue display element BDE. In some example embodiments, the encapsulation layer 300 may be disposed on the opposite electrode 230. Since the display elements may be damaged by moisture or oxygen from the outside, the encapsulation layer 300 may cover the red display element RDE, the green display element GDE, and the blue display element BDE to protect the red display element RDE, the green display element GDE, and the blue display element BDE.

The encapsulation layer 300 may include at least one inorganic layer and at least one organic layer. For example, as illustrated in FIG. 5, the encapsulation layer 300 may include a first inorganic encapsulation layer 310, an organic encapsulation layer 320, and a second inorganic encapsulation layer 330. In some example embodiments, the encapsulation layer 300 including the first inorganic encapsulation layer 310, the second inorganic encapsulation layer 330, and the organic encapsulation layer 320 disposed therebetween may be disposed on the opposite electrode 230.

The first inorganic encapsulation layer 310 covers the opposite electrode 230, and may include silicon oxide (SiO_{X}), silicon nitride (SiN_{X}), and/or silicon oxynitride (SiO_{X}N_{Y}). Since the first inorganic encapsulation layer 310 is formed along a structure therebelow, an upper surface thereof may not be flat (or planar) as illustrated in FIG. 5. The organic encapsulation layer 320 covers the first inorganic encapsulation layer 310, and unlike the first inorganic encapsulation layer 310, an upper surface thereof may be generally flat or planar.

The organic encapsulation layer 320 may include one or more materials selected from the group consisting of polyethyleneterephthalate, polyethylenenaphthalate, polycarbonate, polyimide, polyethylenesulfonate, polyoxymethylene, polyarylate, and hexamethyldisiloxane. The second inorganic encapsulation layer 330 covers the organic encapsulation layer 320, and may include silicon oxide (SiO_{X}), silicon nitride (SiN_{X}), and/or silicon oxynitride (SiO_{X}N_{Y}).

As such, the encapsulation layer 300 includes the first inorganic encapsulation layer 310, the organic encapsulation layer 320, and the second inorganic encapsulation layer 330, and through such a multi-layer structure, even when a crack occurs in the encapsulation layer 300, the crack may be limited or prevented from being connected or propagated between the first inorganic encapsulation layer 310 and the organic encapsulation layer 320 or between the organic encapsulation layer 320 and the second inorganic encapsulation layer 330. Through this, a path through which moisture or oxygen from the outside penetrates into the display apparatus 10 may be limited or prevented or minimized from being formed.

A light-blocking layer 410 is disposed on the encapsulation layer 300. In some example embodiments, the light-blocking layer 410 may be disposed on the second inorganic encapsulation layer 330. The light-blocking layer 410 may at least partially absorb external light. A transmittance of the light-blocking layer 410 may be equal to or greater than 4.0% (or about 4.0%) and equal to or less than 6.4% (or about 6.4%). Alternatively, an optical density of the light-blocking layer 410 may be equal to or greater than 1.2 (or about 1.2) and equal to or less than 1.4 (or about 1.4).

The light-blocking layer 410 may include a light-blocking material. The light-blocking material may include at least one of graphite, carbon nanotubes, carbon black, and an organic black pigment. The organic black pigment may include at least one of Lactam Black, Perylene Black, and Aniline Black. Alternatively, the light-blocking material may include at least one of metal particles (for example, chromium, nickel, aluminium, or molybdenum), metal oxide particles (for example, chromium oxide), and metal nitride particles (for example, chromium nitride).

The light-blocking layer 410 may define filter openings overlapping pixel openings of the organic bank layer 119. For example, the light-blocking layer 410 may define a red filter opening RFO, a green filter opening GFO, and a blue filter opening BFO. The red filter opening RFO may overlap the red pixel opening RPO. The green filter opening GFO may overlap the green pixel opening GPO, and the blue filter opening BFO may overlap the blue pixel opening BPO.

An area (e.g., a cross-sectional area) of each of the filter openings RFO, GFO, and BFO may be larger than an area of a corresponding pixel opening. In some example embodiments, an area of the red filter opening RFO may be larger than an area (e.g., a cross-sectional area) of the red pixel opening RPO, an area (e.g., a cross-sectional area) of the green filter opening GFO may be larger than an area (e.g., a cross-sectional area) of the green pixel opening GPO, and an area (e.g., a cross-sectional area) of the blue filter opening BFO may be larger than an area (e.g., a cross-sectional area) of the blue pixel opening BPO. In other words, an edge of each of the filter openings in a plan view may surround an edge of a corresponding pixel opening. A width of each of the filter openings may be larger than a width of a corresponding pixel opening. Accordingly, light emitted from the display elements may reach a user with reduced or minimal optical interference.

Color filters may fill (or at least partially occupy) the filter openings of the light-blocking layer 410. The color filters may have a color corresponding to light that an emission layer of a display element disposed below each of the color filters may emit. In some example embodiments, a red color filter R420 may fill the red filter opening RFO, a green color filter G420 may fill the green filter opening GFO, and a blue color filter B420 may fill the blue filter opening BFO. In other words, at least a portion of the red color filter R420 may be disposed in the red filter opening RFO, at least a portion of the green color filter G420 may be disposed in the green filter opening GFO, and at least a portion of the blue color filter B420 may be disposed in the blue filter opening BFO.

Accordingly, the red color filter R420 may overlap (or at least partially overlap) the red display element RDE, the green color filter G420 may overlap (or at least partially overlap) the green display element GDE, and the blue color filter B420 may overlap (or at least partially overlap) the blue display element BDE. Accordingly, the red color filter R420, the green color filter G420, and the blue color filter B420 may prevent or reduce or limit external light reflection of the display apparatus 10. For example, a red color filter R420 that allows only red light to pass therethrough may be disposed on the red display element RDE, a green color filter G420 that allows only green light to pass therethrough may be disposed on the green display element GDE, and a blue color filter B420 that allows only blue light to pass therethrough may be disposed on the blue display element BDE.

In this case, when external light that is white light is incident on, for example, the red color filter R420, blue light and green light are absorbed by the red color filter R420 and only red light passes through the red color filter R420, is then reflected by the pixel electrode (e.g., the red pixel electrode R210), passes through the red color filter R420 again, and is emitted to the outside. Such an effect may also be applied to the green color filter G420 and the blue color filter B420. Accordingly, in the case of the display apparatus 10 having the red color filter R420, the green color filter G420, and the blue color filter B420, external light reflection is reduced to approximately one third compared to a display apparatus not having color filters.

The red color filter R420, the green color filter G420, and the blue color filter B420 may include a red, green, or blue pigment or dye. In some example embodiments, the red color filter R420 may include a red pigment or dye, the green color filter G420 may include a green pigment or dye, and the blue color filter B420 may include a blue pigment or dye. However, example embodiments are not limited thereto, and a material used to form a red, green, or blue color filter may be included in the red color filter R420, the green color filter G420, and the blue color filter B420 of the disclosure. In some example embodiments, the red color filter R420, the green color filter G420, and the blue color filter B420 may further include quantum dots in addition to the pigments or dyes described above. In some example embodiments, the red color filter R420, the green color filter G420, and the blue color filter B420 may include scattering particles such as titanium oxide.

A color filter planarization layer may be disposed on the light-blocking layer 410 and the red color filter R420, the green color filter G420, and the blue color filter B420. The color filter planarization layer is a colorless light-transmitting layer that does not have a color in a visible light band, and may planarize upper portions of the color filters. The color filter planarization layer may include a colorless light-transmitting organic material such as an acrylic resin. For example, the color filter planarization layer may include an organic material such as acrylic, Benzocyclobutene (BCB), or hexamethyldisiloxane (HMDSO).

In some example embodiments, a plurality of adjacent color filters may not overlap each other. For example, the plurality of color filters may be disposed on the light-blocking layer 410, and the plurality of adjacent color filters may be disposed spaced apart from each other so as not to overlap each other on the light-blocking layer 410. In some example embodiments, a plurality of adjacent color filters may overlap (or at least partially overlap) each other. For example, the plurality of color filters may be disposed on the light-blocking layer 410, and the plurality of adjacent color filters may overlap each other on the light-blocking layer 410. In some example embodiments, the plurality of color filters may not be disposed on the light-blocking layer 410, and the plurality of color filters may be disposed only in the filter openings (e.g., RFO, GFO, and BFO) of the light-blocking layer 410.

In addition, a light control layer LC may be disposed on the encapsulation layer 300. In some example embodiments, the light control layer LC may be disposed between the light-blocking layer 410 and the encapsulation layer 300 and/or between the color filters (R420, G420, and B420) and the encapsulation layer 300. The light control layer LC may at least partially absorb internal reflected light. In some example embodiments, the light control layer LC may prevent or reduce or limit reflection of light by a layer disposed below the light control layer LC, for example, the opposite electrode 230.

A transmittance of the light control layer LC may be equal to or greater than 19.9% (or about 19.9%) and equal to or less than 70.8% (or about 70.8%). Alternatively, an optical density of the light control layer LC may be equal to or greater than 0.15 (or about 0.15) and equal to or less than 0.7 (or about 0.7).

The light control layer LC may include a light-blocking material. The light-blocking material may include at least one of graphite, carbon nanotubes, carbon black, and an organic black pigment. The organic black pigment may include at least one of Lactam Black, Perylene Black, and Aniline Black. Alternatively, the light-blocking material may include at least one of metal particles (for example, chromium, nickel, aluminium, or molybdenum), metal oxide particles (for example, chromium oxide), and metal nitride particles (for example, chromium nitride).

Alternatively, the light control layer LC may include at least one of an organic pigment, an inorganic pigment, or a composite material thereof. For example, the organic pigment may include at least one of an insoluble azo pigment, a phthalocyanine pigment, a quinacridone pigment, an isoindolinone pigment, an isoindoline pigment, a perylene pigment, a perinone pigment, a dioxazine pigment, an anthraquinone pigment, a dianthraquinonyl pigment, an anthrapyrimidine pigment, an anthanthrone pigment, an indanthrone pigment, a flavanthrone pigment, a pyranthrone pigment, or a diketopyrrolopyrrole pigment. As the inorganic pigment, a metal compound such as a metal oxide or a metal complex salt may be used. For example, the inorganic pigment may include at least one of an oxide or a composite metal oxide of a metal such as iron (Fe), cobalt (Co), aluminium (Al), cadmium (Cd), lead (Pb), copper (Cu), titanium (Ti), magnesium (Mg), chromium (Cr), zinc (Zn), or antimony (Sb).

The light control layer LC includes a material similar to the light-blocking layer 410 described above, but a transmittance and an optical density of the light control layer LC may be different from a transmittance and an optical density of the light-blocking layer 410 described above. The transmittance and the optical density of the light control layer LC may be achieved by adjusting a ratio of materials included in the light control layer LC or by adjusting a concentration of materials included in the light control layer LC. For the sake of brevity, a detailed description of the process of obtaining the preset or desired transmittance and optical density of the light control layer LC through such adjustment is omitted.

In some example embodiments, as illustrated in FIG. 5, the light control layer LC is disposed between the light-blocking layer 410 and the encapsulation layer 300, and may define control openings overlapping pixel openings of the organic bank layer 119. For example, the light control layer LC may define a red control opening RCO, a green control opening GCO, and a blue control opening BCO. The red control opening RCO may overlap the red pixel opening RPO. The green control opening GCO may overlap the green pixel opening GPO, and the blue control opening BCO may overlap the blue pixel opening BPO.

An area (e.g., a cross-sectional area) of each of the control openings (RCO, GCO, and BCO) may be smaller than or equal to an area of a corresponding pixel opening. In some example embodiments, an area of the red control opening RCO may be smaller than or equal to an area of the red pixel opening RPO, an area of the green control opening GCO may be smaller than or equal to an area of the green pixel opening GPO, and an area of the blue control opening BCO may be smaller than or equal to an area of the blue pixel opening BPO. An edge of each of the control openings in a plan view may be surrounded by an edge of a corresponding pixel opening, or an edge of each of the control openings in a plan view may be identical to an edge of a corresponding pixel opening. A width of each of the control openings may be smaller than or equal to a width of a corresponding pixel opening.

A portion of the light control layer LC may overlap a portion of a pixel opening in a direction perpendicular to the substrate 100. A portion of the light control layer LC may overlap a portion of a pixel opening in a plan view. In addition, a portion of the light control layer LC may overlap a portion of a filter opening in a direction perpendicular to the substrate 100. A portion of the light control layer LC may overlap a portion of a filter opening in a plan view, and accordingly, the light control layer LC may adjust a transmittance of light emitted by a display element or may adjust external light reflection. In some example embodiments, a portion of the light control layer LC overlapping a portion of a pixel opening in a plan view may reduce luminance of light emitted by a display element or may reduce external light reflection.

A degree (or distance) by which the light control layer LC protrudes in a direction from an edge of a pixel opening to a central portion of the pixel opening in a plan view may be different depending on an area (for example, the center area CA or the edge area EA) in which the light control layer LC is disposed.

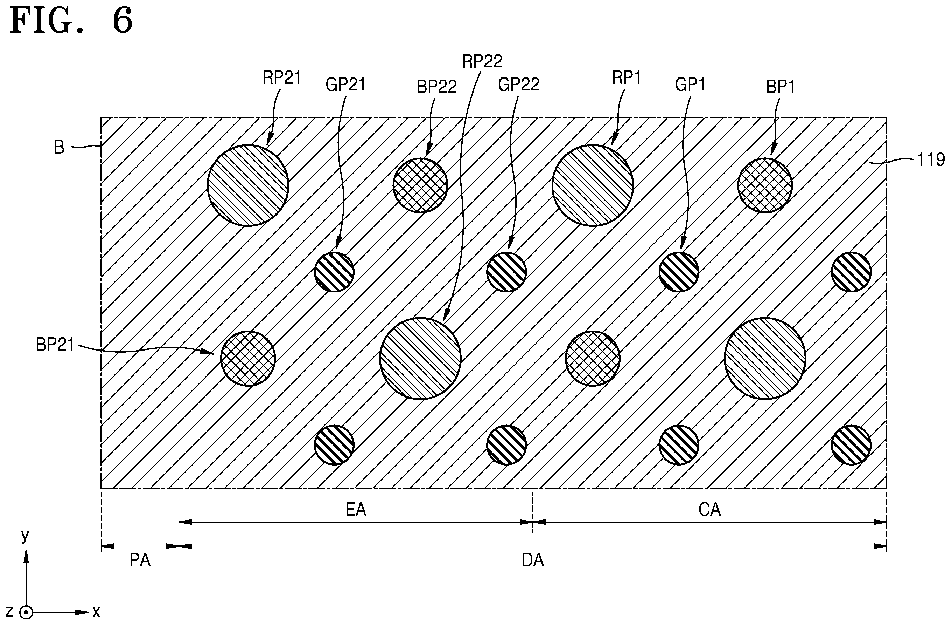

FIG. 6 is a view for explaining pixels distinguished according to positions in a display area DA. FIG. 6 corresponds to portion B of the display apparatus 10 of FIG. 2. FIG. 6 is a plan view schematically illustrating an enlarged portion B of the display apparatus 10 of FIG. 2, and is a plan view of the organic bank layer 119.

As described above, a plurality of pixels may be disposed in the display area DA, and the plurality of pixels may include a red pixel RP, a green pixel GP, and a blue pixel BP. Accordingly, a red pixel RP, a green pixel GP, and a blue pixel BP may be disposed in the center area CA of the display area DA, and a red pixel RP, a green pixel GP, and a blue pixel BP may be disposed in the edge area EA of the display area DA.

Hereinafter, a red pixel RP disposed in the center area CA is referred to as a first red pixel RP1, a green pixel GP disposed in the center area CA is referred to as a first green pixel GP1, and a blue pixel BP disposed in the center area CA is referred to as a first blue pixel BP1. Meanwhile, a red pixel RP disposed in the edge area EA to be adjacent to the peripheral area PA is referred to as a 2-1 red pixel RP21, and a red pixel RP disposed in the edge area EA to be adjacent to the center area CA than the 2-1 red pixel RP21 is referred to as a 2-2 red pixel RP22.

Similarly, a green pixel GP disposed in the edge area EA adjacent to the peripheral area PA is referred to as a 2-1 green pixel GP21, and a green pixel GP disposed in the edge area EA adjacent to the center area CA than the 2-1 green pixel GP21 is referred to as a 2-2 green pixel GP22. A blue pixel BP disposed in the edge area EA adjacent to the peripheral area PA is referred to as a 2-1 blue pixel BP21, and a blue pixel BP disposed in the edge area EA adjacent to the center area CA than the 2-1 blue pixel BP21 is referred to as a 2-2 blue pixel BP22.

As described above, a degree (or distance) by which the light control layer LC protrudes in a direction from an edge of a pixel opening to a central portion of the pixel opening in a plan view may be different depending on an area (for example, the center area CA or the edge area EA) in which the light control layer LC is disposed. A relationship between a position of the light control layer LC and a degree of protrusion of the light control layer LC is the same for the red pixel RP, the green pixel GP, and the blue pixel BP. For the sake of convenience of explanation, a description will be provided below with reference to the green pixel GP.

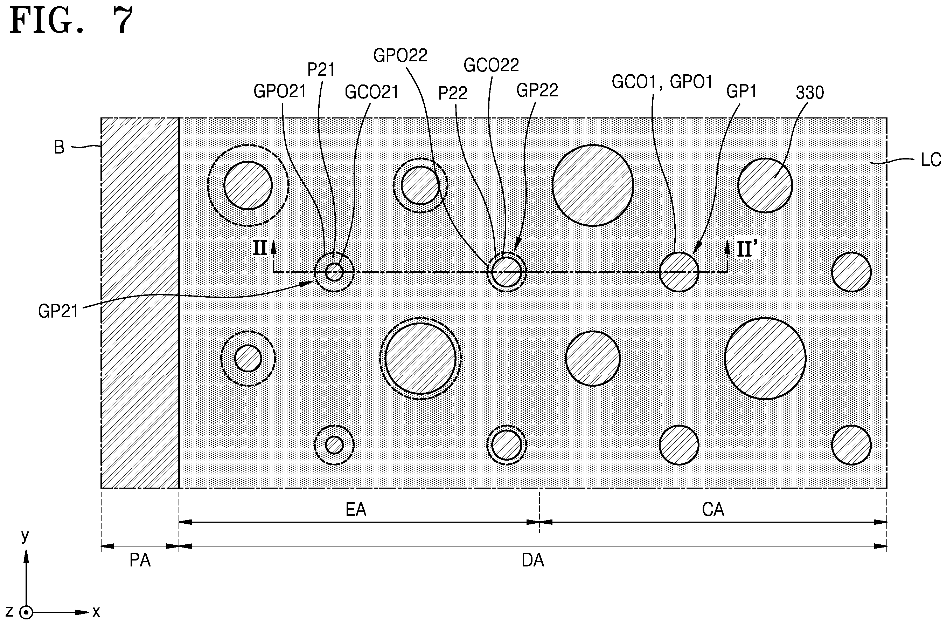

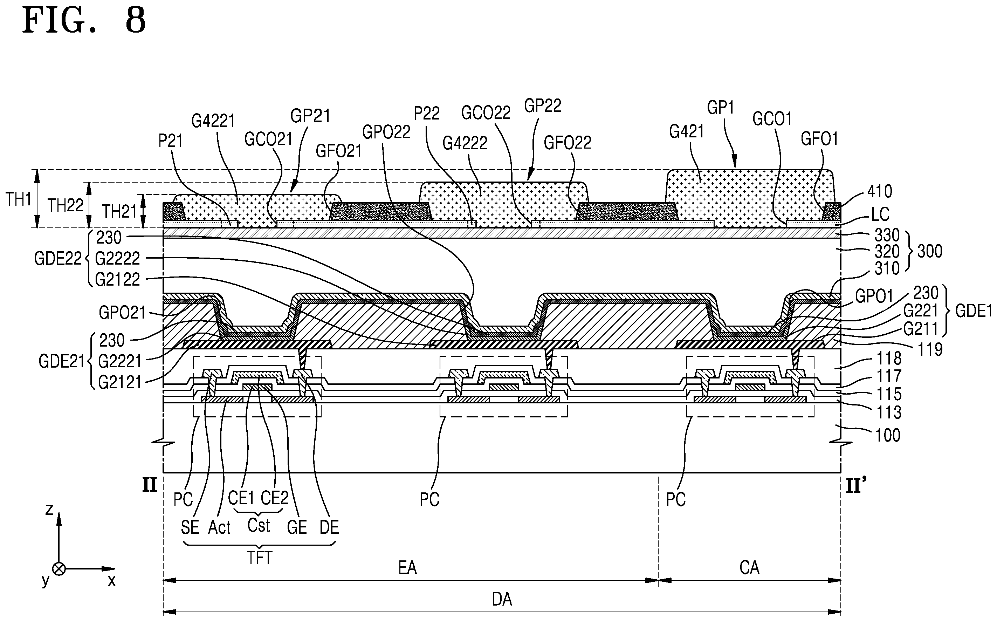

FIG. 7 is a plan view schematically illustrating an enlarged portion B of the display apparatus 10 of FIG. 2. FIG. 8 is a cross-sectional view schematically illustrating a cross-section taken along line II-II' of the display apparatus 10 of FIG. 7. In FIG. 7, a plan view on the light control layer LC is illustrated for convenience. However, for convenience of description, pixel openings defined by the organic bank layer 119 disposed below the light control layer LC are also illustrated in FIG. 7. FIG. 7 corresponds to FIG. 6, and in FIG. 7, the pixel openings are indicated by dotted lines.

The above description of the green pixel GP with reference to FIG. 5 is applicable to the first green pixel GP1, the 2-1 green pixel GP21, and the 2-2 green pixel GP22. In some example embodiments, as described above with reference to FIG. 5, a green display element GDE corresponds to the green pixel GP. Hereinafter, referring to FIG. 8, for the sake of description, a green display element GDE corresponding to the first green pixel GP1 is referred to as a first display element GDE1, a green display element GDE corresponding to the 2-1 green pixel GP21 is referred to as a 2-1 display element GDE21, and a green display element GDE corresponding to the 2-2 green pixel GP22 is referred to as a 2-2 display element GDE22.

As described above with reference to FIG. 5, the green display element GDE includes a green pixel electrode G210. Hereinafter, referring to FIG. 8, for the sake of description, a green pixel electrode G210 included in the first display element GDE1 is referred to as a first pixel electrode G211, a green pixel electrode G210 included in the 2-1 display element GDE21 is referred to as a 2-1 pixel electrode G2121, and a green pixel electrode G210 included in the 2-2 display element GDE22 is referred to as a 2-2 pixel electrode G2122.

The first pixel electrode G211 may be disposed on the center area CA. The 2-1 pixel electrode G2121 may be disposed on the edge area EA. The 2-2 pixel electrode G2122 may be disposed on the edge area EA to be disposed closer to the center area CA than the 2-1 pixel electrode G2121. The opposite electrode 230 may be disposed on the first pixel electrode G211, the 2-1 pixel electrode G2121, and the 2-2 pixel electrode G2122.

As described above with reference to FIG. 5, the organic bank layer 119 defines a green pixel opening GPO exposing a central portion of the green pixel electrode G210. Referring to FIG. 8, for the sake of description, a green pixel opening GPO exposing a central portion of the first pixel electrode G211 is referred to as a first pixel opening GPO1, a green pixel opening GPO exposing a central portion of the 2-1 pixel electrode G2121 is referred to as a 2-1 pixel opening GPO21, and a green pixel opening GPO exposing a central portion of the 2-2 pixel electrode G2122 is referred to as a 2-2 pixel opening GPO22.

The organic bank layer 119 may define the first pixel opening GPO1, the 2-1 pixel opening GPO21, and the 2-2 pixel opening GPO22. The first pixel opening GPO1 may expose a central portion of the first pixel electrode G211. The 2-1 pixel opening GPO21 may expose a central portion of the 2-1 pixel electrode G2121. The 2-2 pixel opening GPO22 may expose a central portion of the 2-2 pixel electrode G2122.

As described above with reference to FIG. 5, the green display element GDE includes a green emission layer G220. Referring to FIG. 8, for the sake of description, a green emission layer G220 included in the first display element GDE1 is referred to as a first emission layer G221, a green emission layer G220 included in the 2-1 display element GDE21 is referred to as a 2-1 emission layer G2221, and a green emission layer G220 included in the 2-2 display element GDE22 is referred to as a 2-2 emission layer G2222.

The first emission layer G221 may be disposed between the first pixel electrode G211 and the opposite electrode 230. The 2-1 emission layer G2221 may be disposed between the 2-1 pixel electrode G2121 and the opposite electrode 230. The 2-2 emission layer G2222 may be disposed between the 2-2 pixel electrode G2122 and the opposite electrode 230. The first emission layer G221, the 2-1 emission layer G2221, and the 2-2 emission layer G2222 may emit light of the same color.

As described above with reference to FIG. 5, the light control layer LC defines a green control opening GCO overlapping the green pixel opening GPO. Referring to FIG. 8, for the sake of description, a green control opening GCO overlapping the first pixel opening GPO1 is referred to as a first control opening GCO1, a green control opening GCO overlapping the 2-1 pixel opening GPO21 is referred to as a 2-1 control opening GCO21, and a green control opening GCO overlapping the 2-2 pixel opening GPO22 is referred to as a 2-2 control opening GCO22.

The light control layer LC is disposed on the center area CA and the edge area EA, and may define the first control opening GCO1, the 2-1 control opening GCO21, and the 2-2 control opening GCO22. The first control opening GCO1 may overlap the first pixel opening GPO1. The 2-1 control opening GCO21 may overlap the 2-1 pixel opening GPO21. The 2-2 control opening GCO22 may overlap the 2-2 pixel opening GPO22. In FIG. 8, the light control layer LC is illustrated as being disposed between the light-blocking layer 410 and the encapsulation layer 300, but example embodiments are not limited thereto.

As described above with reference to FIG. 5, the light-blocking layer 410 defines a green filter opening GFO overlapping the green pixel opening GPO. Referring to FIG. 8, for the sake of description, a green filter opening GFO overlapping the first pixel opening GPO1 is referred to as a first filter opening GFO1, a green filter opening GFO overlapping the 2-1 pixel opening GPO21 is referred to as a 2-1 filter opening GFO21, and a green filter opening GFO overlapping the 2-2 pixel opening GPO22 is referred to as a 2-2 filter opening GFO22.

The light-blocking layer 410 may define the first filter opening GFO1, the 2-1 filter opening GFO21, and the 2-2 filter opening GFO22. The first filter opening GFO1 may overlap the first pixel opening GPO1. The 2-1 filter opening GFO21 may overlap the 2-1 pixel opening GPO21. The 2-2 filter opening GFO22 may overlap the 2-2 pixel opening GPO22.

As described above with reference to FIG. 5, at least a portion of the green color filter G420 is disposed in the green filter opening GFO. Referring to FIG. 8, for the sake of description, a green color filter G420 at least a portion of which is disposed in the first filter opening GFO1 is referred to as a first color filter G421, a green color filter G420 at least a portion of which is disposed in the 2-1 filter opening GFO21 is referred to as a 2-1 color filter G4221, and a green color filter G420 at least a portion of which is disposed in the 2-2 filter opening GFO22 is referred to as a 2-2 color filter G4222.

At least a portion of the first color filter G421 may be disposed in the first filter opening GFO1. At least a portion of the 2-1 color filter G4221 may be disposed in the 2-1 filter opening GFO21. At least a portion of the 2-2 color filter G4222 may be disposed in the 2-2 filter opening GFO22. The first color filter G421, the 2-1 color filter G4221, and the 2-2 color filter G4222 may include a pigment or dye of the same color. That is, the first color filter G421, the 2-1 color filter G4221, and the 2-2 color filter G4222 may allow light of the same color to pass through.

The first color filter G421, the 2-1 color filter G4221, and the 2-2 color filter G4222 may have different thicknesses from each other. In some example embodiments, as illustrated in FIG. 8, a thickness TH21 of the 2-1 color filter G4221 may be smaller than a thickness TH1 of the first color filter G421. A thickness TH22 of the 2-2 color filter G4222 may be smaller than the thickness TH1 of the first color filter G421 and may be greater than the thickness TH21 of the 2-1 color filter G4221.

As described above, the encapsulation layer 300 may cover the display elements. The encapsulation layer 300 may cover all of the display area DA and a portion of the peripheral area PA. An edge of the encapsulation layer 300 is formed on the peripheral area PA, and the encapsulation layer 300 forms an inclined surface on the peripheral area PA. Accordingly, a portion of the encapsulation layer 300 formed on the edge area EA may have a smaller thickness than a portion of the encapsulation layer 300 formed on the center area CA. Moreover, in a portion of the encapsulation layer 300 formed on the edge area EA, a thickness of the encapsulation layer 300 may become smaller as the portion is closer to the peripheral area PA.

A portion of the encapsulation layer 300 disposed on the edge area EA may have a smaller thickness than a portion of the encapsulation layer 300 disposed on the center area CA. Such a difference in thickness according to positions of the encapsulation layer 300 may also affect thicknesses of color filters formed on the encapsulation layer 300. A color filter formed on the edge area EA may have a smaller thickness than a color filter formed on the center area CA. Moreover, in color filters formed on the edge area EA, a thickness of a color filter may become smaller as the color filter is closer to the peripheral area PA.

Accordingly, the thickness TH21 of the 2-1 color filter G4221 disposed on the edge area EA may be smaller than the thickness TH1 of the first color filter G421 disposed on the center area CA. The 2-2 color filter G4222 is disposed on the edge area EA, but is disposed closer to the center area CA than the 2-1 color filter G4221. Accordingly, the thickness TH22 of the 2-2 color filter G4222 may be smaller than the thickness TH1 of the first color filter G421 and may be greater than the thickness TH21 of the 2-1 color filter G4221.

As described above, a degree to (or a distance by) which the light control layer LC protrudes in a direction from an edge of a pixel opening to a central portion of the pixel opening in a plan view may be different depending on an area (for example, the center area CA or the edge area EA) in which the light control layer LC is disposed. Accordingly, an area in which the light control layer LC overlaps a pixel opening in a plan view may be different depending on an area (for example, the center area CA or the edge area EA) in which the light control layer LC is disposed.

The light control layer LC may overlap pixel openings of the edge area EA. In some example embodiments, as the light control layer LC is closer to the peripheral area PA, a degree to which the light control layer LC protrudes in a direction from an edge of a pixel opening to a central portion of the pixel opening in a plan view may become larger. Accordingly, as the light control layer LC is closer to the peripheral area PA, an area in which the light control layer LC overlaps a pixel opening in a plan view may become larger. Accordingly, as a display element is closer to the peripheral area PA, a degree to which light emitted from the display element reaches a user may become smaller.

For example, as illustrated in FIG. 7, the light control layer LC may include a 2-1 portion P21 overlapping the 2-1 pixel opening GPO21 in a plan view. In addition, as illustrated in FIG. 7, the light control layer LC may include a 2-2 portion P22 overlapping the 2-2 pixel opening GPO22 in a plan view. An area of the 2-2 portion P22 may be smaller than an area (e.g., cross-sectional area) of the 2-1 portion P21. As the light control layer LC is closer to the peripheral area PA, a degree to (or a distance by) which the light control layer LC protrudes in a direction from an edge of a pixel opening to a central portion of the pixel opening in a plan view may become larger.

In other words, an area of the 2-1 control opening GCO21 may be smaller than an area of the 2-1 pixel opening GPO21. An area of the 2-2 control opening GCO22 may be smaller than an area of the 2-2 pixel opening GPO22. An area of the 2-2 control opening GCO22 may be greater than an area of the 2-1 control opening GCO21. In some example embodiments, the light control layer LC may not overlap the first pixel opening GPO1. An area of the first control opening GCO1 may be equal to an area of the first pixel opening GPO1. An area of the first control opening GCO1 may be greater than an area of the 2-1 control opening GCO21 and may be greater than an area of the 2-2 control opening GCO22.

When a color filter disposed on the edge area EA has a relatively smaller thickness than a color filter disposed on the center area CA, external light reflectance of the edge area EA may increase. External light that may be reflected from the edge area EA and the center area CA may be different from each other. Accordingly, the edge area EA may be visually recognized by a user in a band shape of a bright color. In addition, in this case, when the display apparatus provides an image, luminance of the edge area EA may be higher than intended or designed or desired. That is, optical characteristics may be different depending on positions in the display area. Due to such differences in optical characteristics according to positions in the display area, display quality of the display apparatus may be poor.

However, in the display apparatus 10, according to some example embodiments, a color filter disposed on the edge area EA has a smaller thickness than a color filter disposed on the center area CA, but the light control layer LC may overlap pixel openings of the edge area EA. Moreover, as the light control layer LC is closer to the peripheral area PA, an area in which the light control layer LC overlaps a pixel opening in a plan view may become larger. Accordingly, external light that may be reflected from the edge area EA and the center area CA may be similar to each other. In addition, by adjusting an amount of light reaching a user from light emitted from a display element of the edge area EA, when the display apparatus 10 provides an image, luminance of the edge area EA may be implemented or obtained as intended or designed or desired. Accordingly, differences in optical characteristics according to positions in the display area DA may be reduced, and thus display quality of the display apparatus 10 may be improved.

An area in which the light control layer LC overlaps each pixel opening of the edge area EA in a plan view may satisfy a certain condition. As described above, due to differences in thicknesses of color filters according to positions, a degree to (or a distance by) which light emitted by a display element reaches a user may vary depending on a position of the display element. This may cause degradation of display quality of the display apparatus, and thus, to reduce or limit or prevent this, it is desirable for an amount of light emitted by a display element disposed in the edge area EA to reach a user at an appropriate level.

When light that is equal to or greater than 85% and less than 100% of an amount of light emitted by a display element disposed in the edge area EA reaches a user, and when the display apparatus 10 provides an image, luminance of the edge area EA may be implemented or obtained as intended or designed or desired. To this end, when an area of the 2-1 pixel opening GPO21 not overlapping the 2-1 portion P21 in a plan view is A1, an area of the 2-1 pixel opening GPO21 overlapping the 2-1 portion P21 in a plan view is A2, and a transmittance of the light control layer LC is T, A1, A2, and T satisfy Equation 1 below.$0.85 < \frac{A 1 + T \times A 2}{A 1 + A 2} < 1.0 .$ Equation 1

An amount of light emitted from a portion corresponding to A1 does not decrease, but an amount of light emitted from a portion corresponding to A2 decreases. In Equation 1, (A1+T×A2)/(A1+A2) may indicate an amount of light reaching a user from an amount of light emitted by the 2-1 display element GDE21. Equation 1 indicates that an area of the 2-1 portion P21 should be adjusted such that light equal to or greater than 85% and less than 100% of an amount of light emitted by the 2-1 display element GDE21 reaches a user. In addition, an area of the 2-2 portion P22 may be adjusted such that light equal to or greater than 85% and less than 100% of an amount of light emitted by the 2-2 display element GDE22 reaches a user.

In FIG. 7, the light control layer LC is illustrated as not overlapping the first pixel opening GPO1, but example embodiments are not limited thereto.

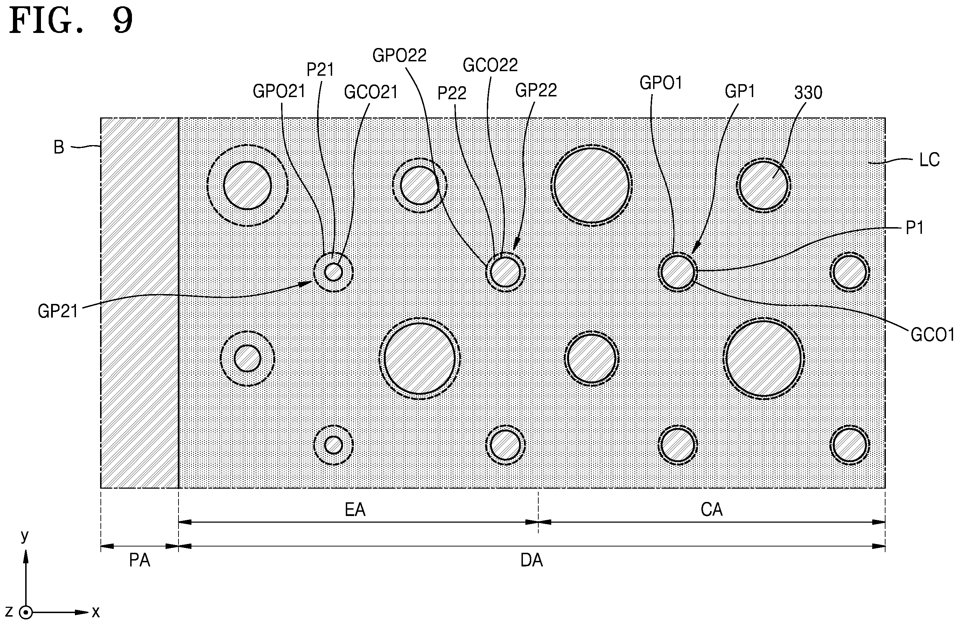

FIG. 9 is a plan view schematically illustrating a display apparatus 10 according to some example embodiments of the disclosure. In FIG. 9, a plan view on the light control layer LC is illustrated for convenience. However, for convenience of description, pixel openings defined by the organic bank layer 119 disposed below the light control layer LC are also illustrated in FIG. 9. FIG. 9 corresponds to FIG. 7. The display apparatus 10 of FIG. 9 may be same as or similar in some respects to the display apparatus 10 described above with reference to FIGS. 2 to 8, and therefore may be best understood with reference thereto where like numerals indicate like elements not described again in detail.

As illustrated in FIG. 9, the light control layer LC of the display apparatus 10 may also overlap the 2-1 pixel opening GPO21 and the 2-2 pixel opening GPO22 in a plan view. In other words, the light control layer LC of the display apparatus 10 may also include a 2-1 portion P21 overlapping the 2-1 pixel opening GPO21 in a plan view, and may include a 2-2 portion P22 overlapping the 2-2 pixel opening GPO22 in a plan view.

However, the light control layer LC of the display apparatus 10 of FIG. 9 may also overlap the first pixel opening GPO1 in a plan view. In other words, the light control layer LC of the display apparatus 10 of FIG. 9 may include a first portion P1 overlapping the first pixel opening GPO1 in a plan view. An area (e.g., cross-sectional area) of the first portion P1 may be smaller than an area (e.g., cross-sectional area) of the 2-1 portion P21. In addition, an area of the first portion P1 may be smaller than an area of the 2-2 portion P22.

Also, in the display apparatus 10 of FIG. 9, the light control layer LC overlaps pixel openings of the edge area EA. Moreover, as the light control layer LC is closer to the peripheral area PA, an area in which the light control layer LC overlaps a pixel opening in a plan view becomes larger. Accordingly, external light that may be reflected from the edge area EA and external light that may be reflected from the center area CA may be similar to each other, and when the display apparatus 10 provides an image, luminance of the edge area EA may be implemented or obtained as intended or desired. Accordingly, differences in optical characteristics according to positions in the display area DA may be reduced, and thus display quality of the display apparatus 10 may be improved.

In FIGS. 7 and 9, the light control layer LC is illustrated as being disposed on the center area CA, but example embodiments are not limited thereto.

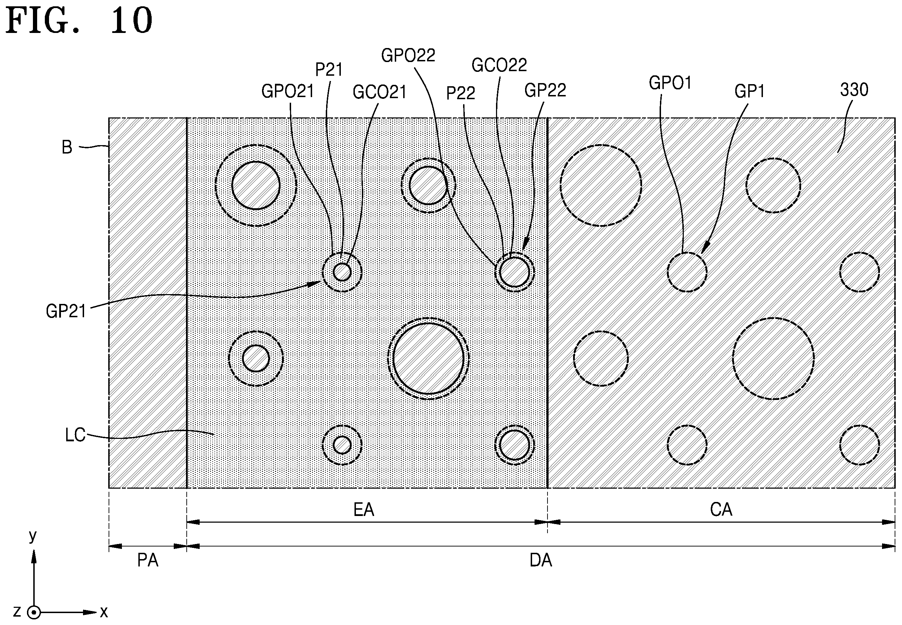

FIG. 10 is a plan view schematically illustrating a display apparatus 10 according to some example embodiments of the disclosure. In FIG. 10, a plan view on the light control layer LC is illustrated for convenience. However, for convenience of description, pixel openings defined by the organic bank layer 119 disposed below the light control layer LC are also illustrated in FIG. 10. FIG. 10 corresponds to FIG. 7. The display apparatus 10 of FIG. 10 may be same as or similar in some respects to the display apparatus 10 described above with reference to FIGS. 2 to 8, and therefore may be best understood with reference thereto where like numerals indicate like elements not described again in detail.

As illustrated in FIG. 10, the light control layer LC of the display apparatus 10 of FIG. 10 may also overlap the 2-1 pixel opening GPO21 and the 2-2 pixel opening GPO22 in a plan view. In other words, the light control layer LC of the display apparatus 10 of FIG. 10 may also include a 2-1 portion P21 overlapping the 2-1 pixel opening GPO21 in a plan view, and may include a 2-2 portion P22 overlapping the 2-2 pixel opening GPO22 in a plan view.

However, the light control layer LC of the display apparatus 10 of FIG. 10 may overlap only the edge area EA in a plan view. The light control layer LC of the display apparatus 10 of FIG. 10 may be disposed only on the edge area EA, and may not be disposed on the center area CA.

In the display apparatus 10, the light control layer LC overlaps pixel openings of the edge area EA. Moreover, as the light control layer LC is closer to the peripheral area PA, an area in which the light control layer LC overlaps a pixel opening in a plan view becomes larger. Accordingly, external light that may be reflected from the edge area EA and external light that may be reflected from the center area CA may be similar to each other, and when the display apparatus 10 provides an image, luminance of the edge area EA may be implemented or obtained as intended, designed or desired. Accordingly, differences in optical characteristics according to positions in the display area DA may be reduced, and thus display quality of the display apparatus 10 may be improved.

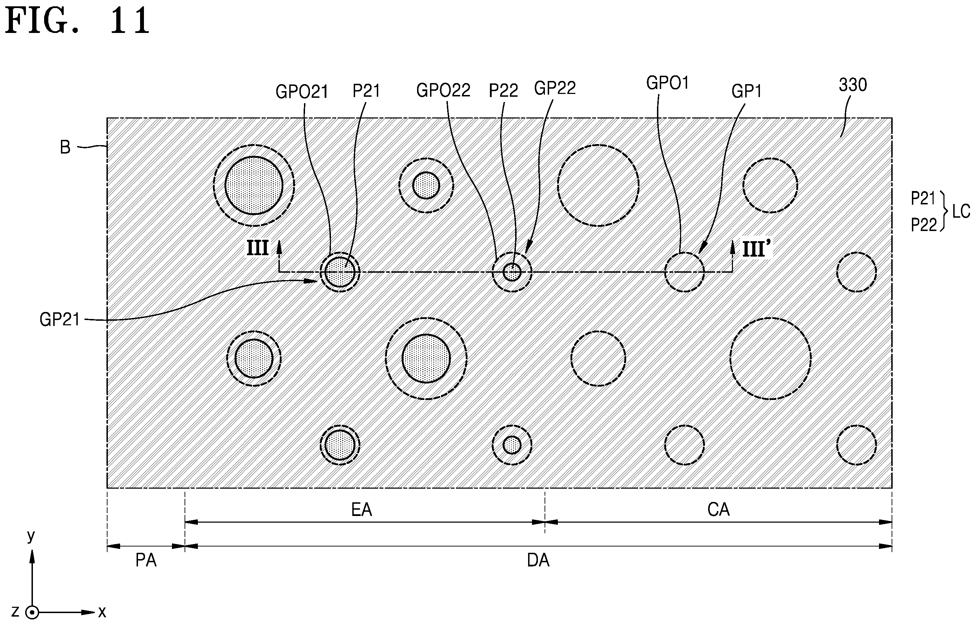

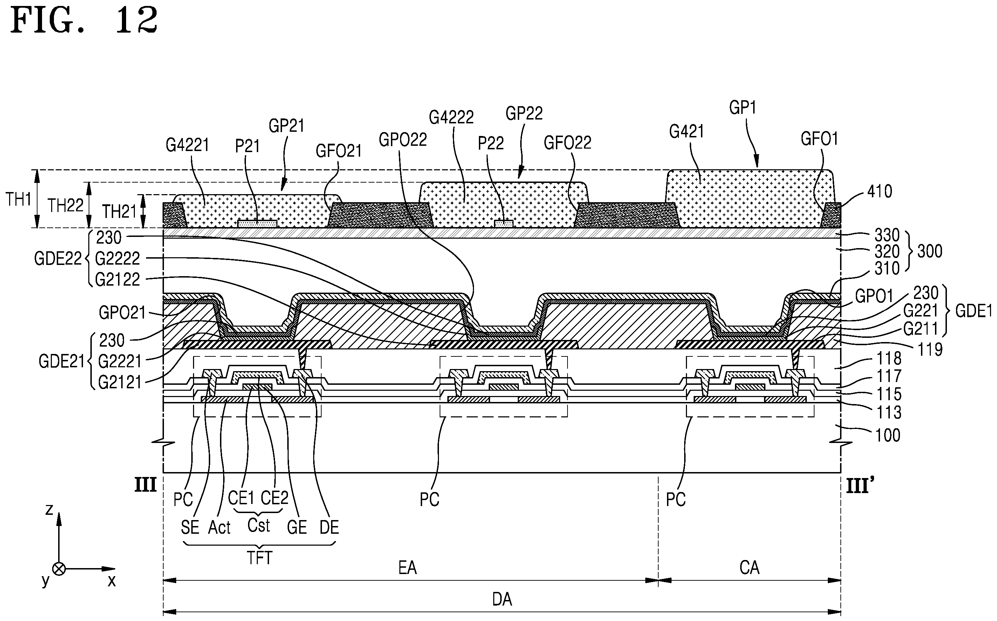

FIG. 11 is a plan view schematically illustrating a display apparatus 10 according to some example embodiments of the disclosure. FIG. 12 is a cross-sectional view schematically illustrating a cross-section taken along line III-III' of the display apparatus 10 of FIG. 11. In FIG. 11, a plan view on the light control layer LC is illustrated for convenience. However, for convenience of description, pixel openings defined by the organic bank layer 119 disposed below the light control layer LC are also illustrated in FIG. 11. FIG. 11 corresponds to FIG. 7, and FIG. 12 corresponds to FIG. 8. The display apparatus 10 of FIG. 11 may be same as or similar in some respects to the display apparatus 10 described above with reference to FIGS. 2 to 8, and therefore may be best understood with reference thereto where like numerals indicate like elements not described again in detail.

As illustrated in FIGS. 11 and 12, the light control layer LC of the display apparatus 10 of FIG. 11 may also be disposed on the encapsulation layer 300. In some example embodiments, the light control layer LC of the display apparatus 10 of FIG. 11 may also be disposed on the second inorganic encapsulation layer 330.

However, the light control layer LC of the display apparatus 10 of FIG. 11 may be disposed only between the color filters and the encapsulation layer 300, and may not be disposed between the light-blocking layer 410 and the encapsulation layer 300. The light control layer LC may include the 2-1 portion P21 and the 2-2 portion P22.

In the case of the display apparatus 10 of FIG. 11, the 2-1 portion P21 may be disposed in the 2-1 filter opening GFO21, and may overlap the 2-1 pixel opening GPO21 in a plan view. At least a portion of the 2-1 color filter G4221 may be disposed in the 2-1 filter opening GFO21 to cover the 2-1 portion P21. In other words, the 2-1 portion P21 may be disposed in the 2-1 filter opening GFO21 to overlap the 2-1 pixel opening GPO21 in a plan view. At least a portion of the 2-1 color filter G4221 may be disposed in the 2-1 filter opening GFO21 to cover the 2-1 portion P21.

In the display apparatus 10 of FIG. 11, the 2-2 portion P22 may be disposed in the 2-2 filter opening GFO22, and may overlap the 2-2 pixel opening GPO22 in a plan view. At least a portion of the 2-2 color filter G4222 may be disposed in the 2-2 filter opening GFO22 to cover the 2-2 portion P22. In other words, the 2-2 portion P22 may be disposed in the 2-2 filter opening GFO22 to overlap the 2-2 pixel opening GPO22 in a plan view. At least a portion of the 2-2 color filter G4222 may be disposed in the 2-2 filter opening GFO22 to cover the 2-2 portion P22.

In the display apparatus 10 of FIG. 11, an area (e.g., cross-sectional area) of the 2-2 portion P22 may be smaller than an area (e.g., cross-sectional area) of the 2-1 portion P21. In addition, also in the case of the display apparatus 10 of FIG. 11, when an area of the 2-1 pixel opening GPO21 not overlapping the 2-1 portion P21 in a plan view is A1, an area of the 2-1 pixel opening GPO21 overlapping the 2-1 portion P21 in a plan view is A2, and a transmittance of the light control layer LC is T, A1, A2, and T satisfy Equation 1 below.$0.85 < \frac{A 1 + T \times A 2}{A 1 + A 2} < 1.0 .$ Equation 1

In the display apparatus 10 of FIG. 11, the light control layer LC overlaps pixel openings of the edge area EA. Moreover, the closer to the peripheral area PA, an area in which the light control layer LC overlaps a pixel opening in a plan view becomes larger. Accordingly, external light reflected from the edge area EA and external light reflected from the center area CA may be similar to each other, and when the display apparatus 10 provides an image, luminance of the edge area EA may be implemented or obtained as intended, desired, or designed. Accordingly, differences in optical characteristics according to positions in the display area DA may be reduced, and thus display quality of the display apparatus 10 may be improved.

In FIGS. 11 and 12, the light control layer LC is illustrated as being disposed only on the edge area EA, but example embodiments are not limited thereto.

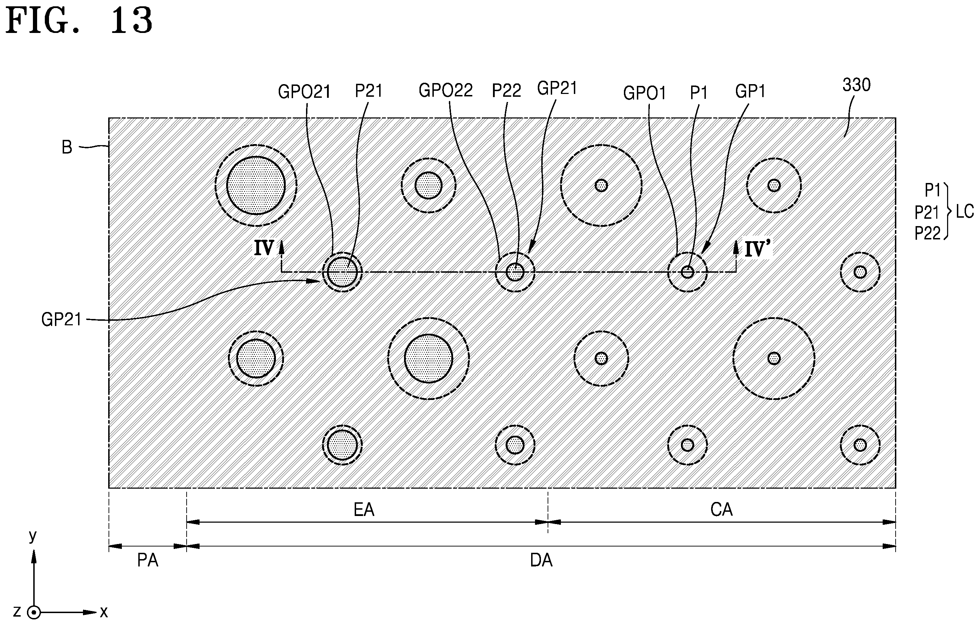

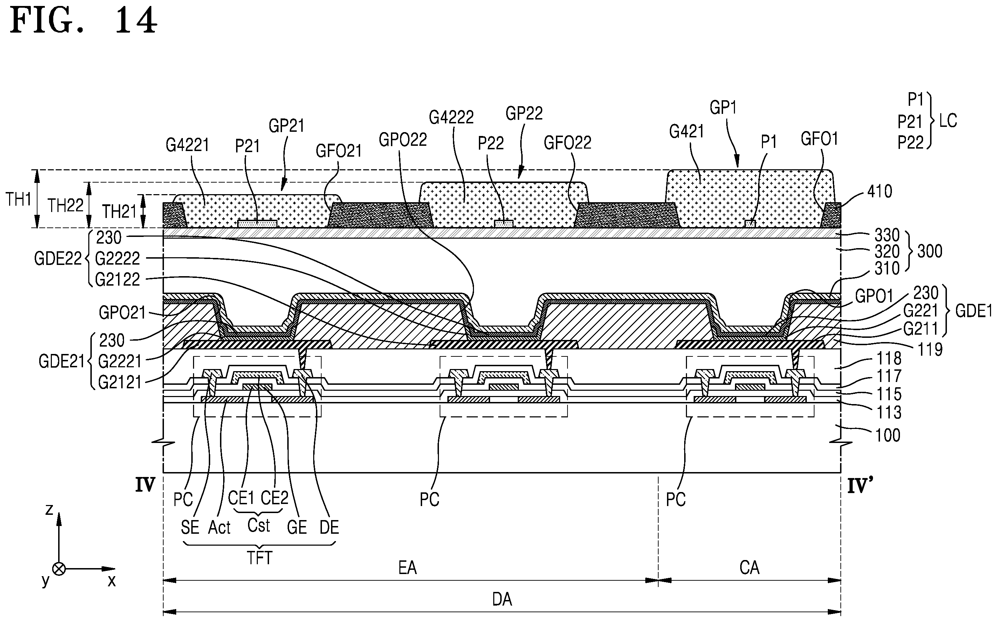

FIG. 13 is a plan view schematically illustrating a display apparatus 10 according to some example embodiments of the disclosure. FIG. 14 is a cross-sectional view schematically illustrating a cross-section taken along line IV-IV' of the display apparatus 10 of FIG. 13. In FIG. 13, a plan view on the light control layer LC is illustrated for convenience. However, for convenience of description, pixel openings defined by the organic bank layer 119 disposed below the light control layer LC are also illustrated in FIG. 13. FIG. 13 corresponds to FIG. 11, and FIG. 14 corresponds to FIG. 12. The display apparatus 10 of FIG. 13 may be same as or similar in some respects to the display apparatus 10 described above with reference to FIGS. 11 and 12, and therefore may be best understood with reference thereto where like numerals indicate like elements not described again in detail.

As illustrated in FIGS. 13 and 14, the light control layer LC of the display apparatus 10 of FIG. 13 may also be disposed only between the color filters and the encapsulation layer 300, and may not be disposed between the light-blocking layer 410 and the encapsulation layer 300. The light control layer LC of the display apparatus 10 of FIG. 13 may also include the 2-1 portion P21 and the 2-2 portion P22.

However, the light control layer LC of the display apparatus 10 of FIG. 13 may further include a first portion P1. The first portion P1 may be disposed in the first filter opening GFO1, and may overlap the first pixel opening GPO1 in a plan view. At least a portion of the first color filter G421 may be disposed in the first filter opening GFO1 to cover the first portion P1. The first portion P1 may be disposed in the first filter opening GFO1 to overlap the first pixel opening GPO1 in a plan view. At least a portion of the first color filter G421 may be disposed in the first filter opening GFO1 to cover the first portion P1.

In the display apparatus 10 of FIG. 13, an area (e.g., cross-sectional area) of the first portion P1 may be smaller than an area (e.g., cross-sectional area) of the 2-1 portion P21. In addition, an area (e.g., cross-sectional area) of the first portion P1 may be smaller than an area (e.g., cross-sectional area) of the 2-2 portion P22.

In the display apparatus 10, the light control layer LC overlaps pixel openings of the edge area EA. Moreover, the closer to the peripheral area PA, an area in which the light control layer LC overlaps a pixel opening in a plan view becomes larger. Accordingly, external light reflected from the edge area EA and external light reflected from the center area CA may be similar to each other, and when the display apparatus 10 provides an image, luminance of the edge area EA may be implemented or obtained as intended, desired or designed. Accordingly, differences in optical characteristics according to positions in the display area DA may be reduced, and thus display quality of the display apparatus 10 may be improved.

In FIGS. 11 and 13, each of the first portion P1, the 2-1 portion P21, and the 2-2 portion P22 is illustrated as having a circular shape, but example embodiments are not limited thereto. For example, each of the first portion P1, the 2-1 portion P21, and the 2-2 portion P22 may have a polygonal shape such as a triangular shape, a pentagonal shape, or a hexagonal shape, a ring shape, an elliptical shape, or an atypical shape.

As described above, the example embodiments have been described with reference to the drawings, but these are merely examples, and those of ordinary skill in the art will understand that various modifications and other equivalent embodiments are possible therefrom. Therefore, the true technical protection scope of the disclosure should be defined by the appended claims.

According to some example embodiments of the disclosure made as described above, a display apparatus and an electronic apparatus capable of improving display quality by reducing differences in optical characteristics according to positions in a display area may be implemented. However, the scope of example embodiments are not limited by these effects.

Example embodiments are not necessarily mutually exclusive. For example, some example embodiments may include one or more features described with reference to one or more figures, and may also include one or more other features described with reference to one or more other figures.

As described herein, any devices, systems, modules, portions, units, controllers, circuits, and/or portions thereof according to any of the example embodiments, and/or any portions thereof (including, without limitation, the display module 11, the processor 12, the memory 13, the power module 14, the smartphone 1a, the tablet personal computer (PC) 1b, the laptop 1c, the television (TV) 1d, the desktop monitor 1e, smart glasses 1f, the head mounted display 1g, the smart watch 1h, the vehicle electronic apparatus 1i, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), a System-on-Chip (SoC), a programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments. The processing circuitry may include electrical components such as at least one of transistors, resistors, capacitors, etc. The processing circuitry may include electrical components such as logic gates including at least one of AND gates, OR gates, NAND gates, NOT gates, etc.

While several embodiments have been provided in the present disclosure, it should be understood that the disclosed systems and methods might be embodied in many other specific forms without departing from the scope of the present disclosure. The present examples are to be considered as illustrative and not restrictive, and the intention is not to be limited to the details given herein. For example, the various elements or components may be combined or integrated in another system or certain features may be omitted, or not implemented.

## Claims

1. A display apparatus (10) comprising:
a substrate (100) including a display area (DA) and a peripheral area (PA) surrounding the display area (DA), the display area (DA) including a center area (CA) and an edge area (EA) surrounding the center area (CA);
a first pixel electrode (G211) on the center area (CA);
a 2-1 pixel electrode (G2121) on the edge area (EA);
an organic bank layer (119) defining a first pixel opening (GPO1) that exposes a central portion of the first pixel electrode (G211) and a 2-1 pixel opening (GPO21) that exposes a central portion of the 2-1 pixel electrode (G2121);
an opposite electrode (230) on the first pixel electrode (G211) and the 2-1 pixel electrode (G2121);
an encapsulation layer (300) on the opposite electrode (230);
a light-blocking layer (410) on the encapsulation layer (300) and defining a first filter opening (GFO1) that overlaps the first pixel opening (GPO1) and a 2-1 filter opening (GFO21) that overlaps the 2-1 pixel opening (GPO21); and
a light control layer (LC) between the encapsulation layer (300) and the light-blocking layer (410), the light control layer (LC) defining a 2-1 control opening (GCO21) that overlaps the 2-1 pixel opening (GPO21) and the light control layer (LC) including a 2-1 portion (P21) that overlaps the 2-1 pixel opening (GPO21) in a plan view.

2. The display apparatus (10) of claim 1, further comprising:
a first emission layer (G221) between the first pixel electrode (G211) and the opposite electrode (230);
a 2-1 emission layer (G2221) between the 2-1 pixel electrode (G2121) and the opposite electrode (230);
a first color filter (G421) having at least a portion thereof in the first filter opening (GFO1); and
a 2-1 color filter (G4221) having at least a portion thereof in the 2-1 filter opening (GFO21).

3. The display apparatus (10) of claim 2,
wherein a thickness (TH21) of the 2-1 color filter (G4221) is smaller than a thickness (TH1) of the first color filter (G421).

4. The display apparatus (10) of any one of claims 1 to 3, further comprising:
a 2-2 pixel electrode (G2122) on the edge area (EA) and closer to the center area (CA) than the 2-1 pixel electrode (G2121), wherein
the organic bank layer (119) defines a 2-2 pixel opening (GPO22) that exposes a central portion of the 2-2 pixel electrode (G2122),
the light-blocking layer (410) defines a 2-2 filter opening (GFO22) that overlaps the 2-2 pixel opening (GPO22),
the light control layer (LC) defines a 2-2 control opening (GCO22) that overlaps the 2-2 pixel opening (GPO22),
the light control layer (LC) includes a 2-2 portion that overlaps the 2-2 pixel opening (GPO22) in a plan view, and
an area of the 2-2 portion (P22) is smaller than an area of the 2-1 portion (P21).

5. The display apparatus (10) of any one of claims 1 to 4,
wherein the light control layer (LC) is on the center area (CA) and the edge area (EA), and
the light control layer (LC) defines a first control opening (GCO1) that overlaps the first pixel opening (GPO1).

6. The display apparatus (10) of claim 5,
wherein an area of the first control opening (GCO1) is equal to an area of the first pixel opening (GPO1).

7. The display apparatus (10) of claim 5,
wherein the light control layer (LC) includes a first portion (P1) that overlaps the first pixel opening (GPO1) in a plan view, and
an area of the first portion (P1) is smaller than an area of the 2-1 portion (P21).

8. The display apparatus (10) of any one of claims 1 to 7,
wherein the encapsulation layer (300) includes a first inorganic encapsulation layer (310), a second inorganic encapsulation layer (330), and an organic encapsulation layer (320),
the first inorganic encapsulation layer (310) is on the opposite electrode (230),
the second inorganic encapsulation layer (330) is on the first inorganic encapsulation layer (310), and
the organic encapsulation layer (320) is between the first inorganic encapsulation layer (310) and the second inorganic encapsulation layer (330).

9. The display apparatus (10) of any one of claims 1 to 8,
wherein:
(i) a transmittance of the light control layer (LC) is equal to or greater than 19.9% and equal to or less than 70.8%, and
a transmittance of the light-blocking layer (410) is equal to or greater than 4.0% and equal to or less than 6.4%; and
(ii) an area A1 of the 2-1 pixel opening (GPO21) that does not overlap the 2-1 portion (P21) in a plan view, an area A2 of the 2-1 pixel opening (GPO21) that overlaps the 2-1 portion (P21) in a plan view, and a transmittance T of the light control layer (LC), satisfy a relationship $0.85 < \frac{A 1 + T \times A 2}{A 1 + A 2} < 1.0 .$

10. A display apparatus (10) comprising:
a substrate (100) including a display area (DA) and a peripheral area (PA) surrounding the display area (DA), the display area (DA) including a center area (CA) and an edge area (EA) surrounding the center area (CA);
a 2-1 pixel electrode (G2121) on the edge area (EA);
a first pixel electrode (G211) on the center area (CA);
an organic bank layer (119) defining a 2-1 pixel opening (GPO21) that exposes a central portion of the 2-1 pixel electrode (G2121) and a first pixel opening (GPO1) that exposes a central portion of the first pixel electrode (G211);
an opposite electrode (230) on the 2-1 pixel electrode (G2121) and the first pixel electrode (G211);
an encapsulation layer (300) on the opposite electrode (230);
a light-blocking layer (410) on the encapsulation layer (300) and defining a 2-1 filter opening (GFO21) that overlaps the 2-1 pixel opening (GPO21) and a first filter opening (GFO1) that overlaps the first pixel opening (GPO1); and
a light control layer (LC) on the encapsulation layer (300), the light control layer including a 2-1 portion (P21) in the 2-1 filter opening (GFO21) that overlaps the 2-1 pixel opening (GPO21) in a plan view.

11. The display apparatus (10) of claim 10, further comprising:
a 2-1 emission layer (G2221) between the 2-1 pixel electrode (G2121) and the opposite electrode (230);
a first emission layer (G221) between the first pixel electrode (G211) and the opposite electrode (230);
a 2-1 color filter (G4221) having at least a portion thereof in the 2-1 filter opening (GFO21) and covering the 2-1 portion (P21); and
a first color filter (G421) having at least a portion thereof in the first filter opening (GFO1), optionally wherein a thickness (TH21) of the 2-1 color filter (G4221) is smaller than a thickness (TH1) of the first color filter (G421).

12. The display apparatus (10) of claim 10 or claim 11, wherein:
(i) the display apparatus (10) further comprises:
a 2-2 pixel electrode (G2122) on the edge area (EA) and closer to the center area (CA) than the 2-1 pixel electrode (G2121), wherein
the organic bank layer (119) defines a 2-2 pixel opening (GPO22) that exposes a central portion of the 2-2 pixel electrode (G2122),
the light-blocking layer (410) defines a 2-2 filter opening (GFO22) that overlaps the 2-2 pixel opening (GPO22),
the light control layer (LC) defines a 2-2 control opening (GCO22) that overlaps the 2-2 pixel opening (GPO22),
the light control layer (LC) includes a 2-2 portion (P22) in the 2-2 filter opening (GFO22) and that overlaps the 2-2 pixel opening (GPO22) in a plan view, and
an area of the 2-2 portion (P22) is smaller than an area of the 2-1 portion (P21); and/or
(ii) the light control layer (LC) includes a first portion (P1) in the first filter opening (GFO1) that overlaps the first pixel opening (GPO1) in a plan view, and
an area of the first portion (P1) is smaller than an area of the 2-1 portion (P21).

13. The display apparatus (10) of any one of claims 10 to 12,
wherein the encapsulation layer (300) includes a first inorganic encapsulation layer (310), a second inorganic encapsulation layer (330), and an organic encapsulation layer (320),
the first inorganic encapsulation layer (310) is on the opposite electrode (230),
the second inorganic encapsulation layer (330) is on the first inorganic encapsulation layer (310), and
the organic encapsulation layer (320) is between the first inorganic encapsulation layer (310) and the second inorganic encapsulation layer (330).

14. The display apparatus (10) of any one of claims 10 to 13,
wherein:
(i) a transmittance of the light control layer (LC) is equal to or greater than 19.9% and equal to or less than 70.8%, and
a transmittance of the light-blocking layer (410) is equal to or greater than 4.0% and equal to or less than 6.4%; and/or
(ii) an area A1 of the 2-1 pixel opening (GPO21) that does not overlap the 2-1 portion (P21) in a plan view, an area A2 of the 2-1 pixel opening (GPO21) that overlaps the 2-1 portion (P21) in a plan view, and a transmittance T of the light control layer (LC) satisfy a relationship $0.85 < \frac{A 1 + T \times A 2}{A 1 + A 2} < 1.0 .$

15. An electronic apparatus (1), comprising:
a display apparatus (10); and
a processor (12) configured to control the display apparatus (10), wherein the display apparatus (10) comprises,
a substrate (100) including a display area (DA), and a peripheral area (PA) surrounding the display area (DA), the display area (DA) including a center area (CA) and an edge area (EA) surrounding the center area (CA);
a 2-1 pixel electrode (G2121) on the edge area (EA);
a first pixel electrode (G211) on the center area (CA);
an organic bank layer (119) defining a 2-1 pixel opening (GPO21) that exposes a central portion of the 2-1 pixel electrode (G2121) and a first pixel opening (GPO1) that exposes a central portion of the first pixel electrode (G211);
an opposite electrode (230) on the 2-1 pixel electrode (G2121) and the first pixel electrode (G211);
an encapsulation layer (300) on the opposite electrode (230);
a light-blocking layer (410) on the encapsulation layer (300) and defining a 2-1 filter opening (GFO21) that overlaps the 2-1 pixel opening (GPO21) and a first filter opening (GFO1) that overlaps the first pixel opening (GPO1); and
a light control layer (LC) between the encapsulation layer (300) and the light-blocking layer (410), wherein
the light control layer (LC) defines a 2-1 control opening (GCO21) that overlaps the 2-1 pixel opening (GPO21), and
the light control layer (LC) includes a 2-1 portion (P21) that overlaps the 2-1 pixel opening (GPO21) in a plan view, optionally wherein the display apparatus (10) comprises:
a 2-1 emission layer (G2221) between the 2-1 pixel electrode (G2121) and the opposite electrode (230);
a first emission layer (G221) between the first pixel electrode (G211) and the opposite electrode (230);
a 2-1 color filter (G4221) having at least a portion thereof in the 2-1 filter opening (GFO21); and
a first color filter (G421) having at least a portion thereof in the first filter opening (GFO1).
